# EUROPÄISCHE PATENTSCHRIFT

(11) **EP 1 771 926 B1**
(45) Veröffentlichungstag und Bekanntmachung des Hinweises auf die Patenterteilung: **09.08.2017**
(21) Anmeldenummer: 05759656.1
(22) Anmeldetag: 24.06.2005
(51) Int. Cl.: H01S 5/14, H01S 5/183, H01S 5/022, H01S 3/109, H01S 5/04, H01S 3/081

(54) **HALBLEITERLASERBAUELEMENT, OPTISCHE VORRICHTUNG FÜR EIN HALBLEITERLASERBAUELEMENT UND VERFAHREN ZUR HERSTELLUNG EINER OPTISCHEN VORRICHTUNG**
SEMICONDUCTOR LASER COMPONENT, OPTICAL DEVICE FOR A SEMICONDUCTOR LASER COMPONENT, AND METHOD FOR PRODUCING AN OPTICAL DEVICE
ELEMENT LASER A SEMI-CONDUCTEUR, DISPOSITIF OPTIQUE D'UN COMPOSANT LASER A SEMI-CONDUCTEURS ET SON PROCEDE DE PRODUCTION

(30) Priorität: 30.07.2004 DE 102004037019; 14.10.2004 DE 102004050118
(43) Veröffentlichungstag der Anmeldung: 11.04.2007
(73) Patentinhaber: OSRAM Opto Semiconductors GmbH, 93055 Regensburg (DE)
(72) Erfinder: KÜHNELT, Michael, 93051 Regensburg (DE); SCHWARZ, Thomas, 93055 Regensburg (DE); SINGER, Frank, 93128 Regenstauf (DE); STEEGMÜLLER, Ulrich, 93055 Regensburg (DE)
(74) Vertreter: Epping - Hermann - Fischer
(86) Internationale Anmeldenummer: PCT/DE2005/001122
(87) Internationale Veröffentlichungsnummer: WO 2006/012819

(56) Entgegenhaltungen:
- EP-A- 1 096 307
- WO-A-97/22166
- DE-A1- 10 241 192
- DE-A1- 10 253 907
- US-A1- 2003 123 495
- CORAZZA D J ET AL: "WIDEBAND FOUR CHANNEL OPTICAL TRANSMITTER PACKAGE USING VERTICAL CAVITY SURFACE EMITTING LASER ARRAYS" PROCEEDINGS OF THE SPIE, SPIE, BELLINGHAM, VA, US, Bd. 3005, 12. Februar 1977 (1977-02-12), Seiten 354-359, XP008025771 ISSN: 0277-786X

## Beschreibung

Die Erfindung betrifft ein Halbleiterlaserbauelement mit einem zur Strahlungserzeugung vorgesehenen Halbleiterlaserchip und einem externen Spiegel für einen externen optischen Resonator für den Halbleiterlaserchip, Für eine effiziente Lasertätigkeit im Betrieb eines Halbleiterlaserbauelements mit externem Resonator muss oftmals eine aufwändige räumliche Justage des externen Spiegels bezüglich des Halbleiterlaserchips durchgerührt werden.

In der Druckschrift EP 1 096 307 A2 sind ein optisches System zur Wellenlängenkonversion und ein wellenlängenstabilisierter Laser gemäß dem Oberbegriff des Anspruchs 1 beschrieben. Die Druckschriften US 2003/0123495 A1 und WO 97/22166 A2 beziehen sich auf durchstimmbare Laservorrichtungen mit gefalteten externen Resonatoren. In der Druckschrift DE 102 41 192 A1 wird ein optisch gepumpter Laser angegeben. Eine Aufgabe der Erfindung ist es, ein Halbleiterlaserbauelement mit einem Halbleiterlaserchip und einem externen Spiegel für einen externen optischen Resonator anzugeben, wobei der externe Spiegel bezüglich des Halbleiterlaserchips vereinfacht justierbar ist. Weiterhin ist es eine Aufgabe der Erfindung, eine optische Vorrichtung für ein derartiges Halbleiterlaserbauelement anzugeben, mittels derer die Ausbildung einer besonders kleinen und kompakten Bauform eines Halbleiterlaserbauelements erleichtert wird. Weiterhin ist es eine Aufgabe der Erfindung, ein Herstellungsverfahren für eine optische Vorrichtung anzugeben.

Diese Aufgabe wird durch ein Halbleiterlaserbauelement mit den Merkmalen des Patentanspruchs 1 sowie ein Verfahren zur Herstellung einer optischen Vorrichtung gemäß Patentanspruch 25 gelöst. vorteilhafte Ausgestaltungen und Weiterbildungen der Erfindung sind Gegenstand der abhängigen Patentansprüche.

Ein erfindungsgemäßes Halbleiterlaserbauelement umfasst einen zur Strahlungserzeugung vorgesehenen Halbleiterlaserchip und eine optischen Vorrichtung, die einen Träger, ein auf dem Träger angeordnetes Strahlungsumlenkelement und einen auf dem Träger angeordneten Spiegel umfasst, wobei der Spiegel als externer Spiegel eines externen optischen Resonators für den Halbleiterlaserchip ausgebildet ist, das Strahlungsumlenkelement innerhalb des Resonators angeordnet ist, das Strahlungsumlenkelement zur Umlenkung zumindest eines Teils einer vom Halbleiterlaserchip erzeugten und vom externen Spiegel reflektierten Strahlung ausgebildet ist, der Träger eine laterale Haupterstreckungsrichtung aufweist und der Halbleiterlaserchip dem Träger in vertikaler Richtung zur lateralen Haupterstreckungsrichtung nachgeordnet ist.

Die Justage des externen Spiegels für einen Resonator kann mit Vorteil zumindest teilweise in die Fertigung der optischen Vorrichtung verlagert werden. Insbesondere das Strahlungsumlenkelement und der externe Spiegel können schon entsprechend dem Resonator zueinander vorjustiert sein. Eine aufwändige dreidimensionale Justage des externen Spiegels bezüglich des Halbleiterlaserchips kann über geeignete Vorjustierung der Elemente der optischen Vorrichtung in eine vorteilhaft vereinfachte planare Justage zwischen optischer Vorrichtung und dem Halbleiterlaserchip überführt werden. Das Strahlungsumlenkelement lenkt Strahlung im Resonator in eine Richtung, die im Wesentlichen parallel zur lateralen Haupterstreckungsrichtung des Trägers verläuft. Besonders bevorzugt lenkt das Strahlungsumlenkelement vom externen Spiegel reflektierte Strahlung zumindest teilweise zum Halbleiterlaserchip hin um, der die Strahlung erzeugt und im Resonator zu Laserstrahlung verstärkt werden kann.

Der Resonator ist mittels des Strahlungsumlenkelements gefaltet, wobei der externe Spiegel bevorzugt einen Resonatorendspiegel bildet. Hierdurch wird die Ausbildung einer kleinen kompakten Bauform des Halbleiterlaserbauelements vorteilhaft erleichtert. Gemäß der Erfindung sind das Strahlungsumlenkelement und der externe Spiegel auf dem Träger, beispielsweise jeweils mittels einer durch anodisches Bonden, Kleben oder Löten ausgebildeten Verbindung, befestigt.

Gemäß einer weiteren bevorzugten Ausgestaltung der Erfindung sind das Strahlungsumlenkelement und der externe Spiegel lateral nebeneinander angeordnet. Eine derartige Anordnung wird im Weiteren auch als "laterale Anordnung" bezeichnet. Vorzugsweise ist das Strahlungsumlenkelement hierbei derart ausgebildet, dass es im Halbleiterlaserchip erzeugte Strahlung in Richtung des externen Spiegels umlenkt.

In einer weiteren bevorzugten Ausgestaltung der Erfindung ist der externe Spiegel vom Träger in vertikaler Richtung zur lateralen Haupterstreckungsrichtung beabstandet. Vorzugsweise ist das Strahlungsumlenkelement hierzu zwischen Träger und externem Spiegel angeordnet. Eine derartige Anordnung wird im Weiteren auch als "vertikale Anordnung" bezeichnet.

Gemäß der Erfindung ist der Halbleiterlaserchip ein oberflächenemittierender Halbleiterlaserchip, der mit Vorzug, im Gegensatz zu einem kantenemittierenden Laser, eine im Wesentlichen vertikale Emissionsrichtung zur Oberfläche des Halbleiterlaserchips aufweist. Beispielsweise ist der Halbleiterlaserchip als VECSEL (Vertical External Cavity Surface Emitting Laser) oder Halbleiterscheibenlaser ausgebildet. Die optische Vorrichtung ist derart ausgebildet, dass das Strahlungsumlenkelement die vom Halbleiterlaserchip, insbesondere vertikal, emittierte Strahlung in eine Richtung im Wesentlichen parallel zur lateralen Haupterstreckungsrichtung des Trägers zum externen Spiegel hin umlenkt.

Der Halbleiterlaserchip kann zur Strahlungserzeugung in einem aktiven Bereich mittels einer oder mehrerer Pumpstrahlungsquellen optisch gepumpt sein. Die Wellenlänge der Pumpstrahlung ist zweckmäßigerweise kleiner als die der vom Halbleiterlaserchip emittierten Strahlung. Vorzugsweise wird der Halbleiterlaserchip lateral - im Wesentlichen parallel zur Emissionsoberfläche des Halbleiterlaserchips - optisch gepumpt. Eine als kantenemittierender Halbleiterlaser ausgebildete Pumpstrahlungsquelle ist zum optischen Pumpen des Halbleiterlaserchips besonders geeignet.

In einer bevorzugten Ausgestaltung der Erfindung sind die Pumpstrahlungsquelle(n) und ein zu pumpender aktiver Bereich des Halbleiterlaserchips monolithisch in den Halbleiterlaserchip integriert. Hierbei sind den Halbleiterlaserchip und die Pumpstrahlungsquellen definierende Strukturen auf einem gemeinsamen Aufwachssubstrat mittels Epitaxie hergestellt. Beispielsweise wird zuerst eine Schichtstruktur mit dem zu pumpenden aktiven Bereich auf dem Aufwachssubstrat gewachsen und nachfolgend bereichsweise vom Aufwachssubstrat entfernt, wobei in den entfernten Bereichen die Pumpstrahlungsquelle auf dem Aufwachssubstrat gewachsen werden kann. Der aktive Bereich des Halbleiterlaserchips kann beispielsweise innerhalb oder außerhalb eines Resonators der Pumpstrahlungsquelle angeordnet sein.

Gegebenenfalls kann der Halbleiterlaserchip auch mittels einer externen, nicht im Halbleiterlaserchip integrierten Pumpstrahlungsquelle, etwa einem externen Laser, optisch gepumpt sein. Eine unter einem Winkel von ungefähr 45° zur Emissionsoberfläche auf den Halbleiterlaserchip treffende Pumpstrahlung hat sich als besonders geeignet herausgestellt. Gemäß der Erfindung ist der Träger vom Halbleiterlaserchip mittels mindestens eines Beabstandungselements, vorzugsweise einer Mehrzahl von Beabstandungselementen, beabstandet. Ein Beabstandungselement kann vorteilhaft vor der Montage bzw. Justage der optischen Vorrichtung am Träger befestigt oder im Träger ausgebildet sein. Das Beabstandungselement kann beispielsweise ein Glas, Silizium oder eine Keramik enthalten.

Zur Befestigung eines Beabstandungselements am Träger eignen sich beispielsweise anodisches Bonden, Kleben oder Löten. Wird ein Beabstandungselement im Träger ausgebildet, kann dies über entsprechende Strukturierung des Trägers erfolgen. Beispielsweise enthält der Träger ein Glas oder ein Halbleitermaterial, etwa Si oder auch GaAs.

Zur Strukturierung von Beabstandungselementen sind beispielsweise Sandstrahlverfahren, insbesondere für Gläser, oder Ätzverfahren, insbesondere für Halbleitermaterialien, wie Si, besonders geeignet. Weiterhin kann ein Beabstandungselement mittels Sägen aus dem Träger strukturiert werden. Gegebenenfalls wird das Beabstandungselement nach dem Strukturierungsvorgang noch mittels Schleifen und/oder Polieren behandelt. Mittels derartiger Verfahren kann im Träger eine Kavität für den Halbleiterlaserchip ausgebildet werden, wobei die Wand der Kavität das Beabstandungselement bildet.

In einer vorteilhaften Weiterbildung der Erfindung ist die optische Vorrichtung als Gehäuseteil für ein Gehäuse des Halbleiterlaserbauelements ausgebildet. Der Halbleiterlaserchip wird durch das Gehäuse vorteilhaft vor schädlichen äußeren Einflüssen geschützt.

In einer weiteren bevorzugten Ausgestaltung der Erfindung ist der Halbleiterlaserchip auf einem Chipträger, der etwa eine Wärmesenke und/oder Anschlüsse zur elektrischen Kontaktierung des Halbleiterlaserchips bzw. der Pumpstrahlungsquelle umfasst, vormontiert und die optische Vorrichtung ist dem Halbleiterlaserchip nach der Vormontage nachgeordnet. Bevorzugt ist die optische Vorrichtung auf dem Chipträger mittels einer Bond-, Klebe-, oder Lötverbindung befestigt. Besonders bevorzugt ist die optische Vorrichtung über das oder die Beabstandungselement(e) auf dem Chipträger befestigt. Ein DBC-Substrat (Direct Bond Copper) ist als Chipträger besonders geeignet.

In einer weiteren bevorzugten Ausgestaltung der Erfindung sind das Strahlungsumlenkelement und der externe Spiegel auf der dem Halbleiterlaserchip zugewandten Seite des Trägers angeordnet. Hierdurch kann der Abstand von Halbleiterlaserchip und Strahlungsumlenkelement vorteilhaft gering gehalten werden und die Ausbildung einer vorteilhaft kompakten und-kleinen Bauform des Halbleiterlaserbauelements wird in der Folge erleichtert.

Gemäß einer weiteren bevorzugten Ausgestaltung der Erfindung sind das Strahlungsumlenkelement und der externe Spiegel auf der dem Halbleiterlaserchip abgewandten Seite des Trägers angeordnet. Bevorzugt wird der Träger hierbei von der im Halbleiterlaserchip erzeugten Strahlung durchstrahlt. Hierzu kann der Träger beispielsweise eine entsprechend über dem Halbleiterlaserchip angeordnete Aussparung, etwa ein Loch oder einen Spalt, aufweisen, die zum Beispiel mittels Ätzen, Wasserstrahlschneiden oder Bohren in den Träger eingebracht sein kann. Die Zugänglichkeit des Resonators von außen wird durch eine derartige Anordnung von externem Spiegel und Strahlungsumlenkelement erleichtert.

In einer weiteren bevorzugten Ausgestaltung der Erfindung ist im Resonator ein nichtlineares optisches Element zur Frequenzkonversion, vorzugsweise zur Frequenzvervielfachung, angeordnet. Das nichtlineare optische Element ist bevorzugt auf dem Träger angeordnet oder, beispielsweise mittels Löten oder Kleben, auf dem Träger befestigt. Über eine Anordnung des nichtlinearen optischen Elements im Resonator und/oder auf dem Träger wird eine kleine, kompakte Bauform des Halbleiterlaserbauelements mit einem nichtlinearen optischen Element weitergehend begünstigt.

Das nichtlineare optische Element ist vorzugsweise zur Frequenzkonversion von Strahlung im Resonator ausgebildet. Beispielsweise kann das nichtlineare optische Element zur Frequenzverdopplung (SHG: Second Harmonic Generation) ausgebildet sein. Bevorzugt ist das nichtlineare optische Element zur Frequenzkonversion von nichtsichtbarer, etwa infraroter, Strahlung, in sichtbare Strahlung dienen. Nicht sichtbare, insbesondere infrarote Strahlung, kann mittels Halbleiterlaserbauelementen auf AlGaAs- oder GaAs-Basis mit externem Resonator besonders effizient erzeugt werden.

In einer vorteilhaften Weiterbildung der Erfindung ist das nichtlineare optische Element zwischen dem externen Spiegel und dem Träger angeordnet. Diese Anordnung ist besonders für die vertikale Anordnung zweckmäßig. Das nichtlineare optische Element ist hierbei besonders bevorzugt zwischen dem externen Spiegel und dem Strahlungsumlenkelement angeordnet und/oder der externe Spiegel ist mittels des nichtlinearen optischen Elements vom Träger beabstandet.

In einer weiteren bevorzugten Ausgestaltung der Erfindung ist das nichtlineare optische Element zwischen dem externen Spiegel und dem Strahlungsumlenkelement angeordnet. Vom Strahlungsumlenkelement zum externen Spiegel hin umgelenkte Strahlung kann somit im nichtlinearen optischen Element ebenso in der Frequenz konvertiert werden wie vom externen Spiegel reflektierte Strahlung. Für die laterale Anordnung ist das nichtlineare optische Element zweckmäßigerweise in lateraler Richtung vom Strahlungsumlenkelement beabstandet. In einer vorteilhaften Weiterbildung der Erfindung ist das nichtlineare optische Element über ein Temperierungselement, das vorzugsweise als Heizwiderstand ausgebildet ist, heizbar und/oder temperaturstabilisierbar. Bevorzugt ist das Temperierungselement im Träger integriert. Enthält der Träger ein Halbleitermaterial kann ein Heizwiderstand als ein im Halbleitermaterial integrierter pn-Übergang ausgeführt sein. Über ein Temperierungselement kann die Gefahr temperaturbedingter Schwankungen im Brechungsindex des nichtlinearen optischen Elements reduziert werden. In der Folge kann mit Vorteil die Frequenz der frequenzkonvertierten Strahlung stabilisiert werden.

In einer weiteren bevorzugten Ausgestaltung der Erfindung ist das Strahlungsumlenkelement oder der externe Spiegel zur Strahlungsauskopplung von Strahlung, vorzugsweise frequenzkonvertierter Strahlung, aus dem Resonator ausgebildet. Das Strahlungsumlenkelement oder der externe Spiegel können hierzu entsprechend für die auszukoppelnden Strahlung hochreflektiv oder hochtransmittiv ausgebildet sein. Beispielsweise kann dies über entsprechende Beschichtungen von Oberflächen des externen Spiegels oder des Strahlungsumlenkelements, etwa metallhaltige und/oder dielektrische Beschichtungen, erreicht werden.

In einer vorteilhaften Weiterbildung der Erfindung erfolgt die Strahlungsauskopplung aus dem Resonator über das Strahlungsumlenkelement unter interner Totalreflexion im Strahlungsumlenkelement.

Das Strahlungsumlenkelement kann als Prisma oder Strahlteiler, vorzugsweise dichroitischer Strahlteiler, ausgebildet sein. Zum Beispiel enthält das Strahlungsumlenkelement ein Glas.

Gegebenenfalls können auch weitere Elemente, wie ein optisches Element zur Strahlformung, etwa eine Linse, ein Element zur Polarisationsselektion, etwa ein Brewster-Element, oder ein Element zur Wellenlängenselektion, etwa ein Wellenlängenfilter, eine wellenlängenselektive Beschichtung oder ein dispersives Element, im Resonator angeordnet sein.

Mittels einer Linse oder einer weiteren Faltung des Resonators mit einem, vorzugsweise gekrümmten, Faltungsspiegel kann eine vorteilhaft geringe Strahltaille der Strahlung im Resonator erzielt werden.

Mit Vorteil können derartige Elemente an dem Träger angeordnet und/oder befestigt sein. Eine weitere Faltung des Resonators, zusätzlich zu einer Faltung am Strahlungsumlenkelement, erfolgt bevorzugt im Wesentlichen parallel zur lateralen Haupterstreckungsrichtung des Trägers.

In einem erfindungsgemäßen Verfahren zur Herstellung einer optischen Vorrichtung, die als Resonatoraufsatz für ein Halbleiterlaserbauelement der oben genannten Art vorgesehen ist, wird zunächst ein Träger bereitgestellt. Nachfolgend werden ein Strahlungsumlenkelement und ein externer Spiegel auf dem Träger angeordnet und vorzugsweise zueinander justiert. Daraufhin wird die optische Vorrichtung fertiggestellt.

Das Strahlungsumlenkelement und der externe Spiegel werden bevorzugt mittels anodischem Bonden auf dem Träger befestigt.

Zwischen dem Strahlungsumlenkelement und dem externen Spiegel kann ein nichtlineares optisches Element auf dem Träger angeordnet und/oder befestigt werden. Zum Beispiel wird das nichtlineare optische Element auf den Träger geklebt oder gelötet.

In einer bevorzugten Ausgestaltung des Verfahrens ist das Verfahren zur gleichzeitigen Herstellung einer Mehrzahl optischer Vorrichtungen ausgebildet.

Hierzu wird gemäß einer vorteilhaften Weiterbildung der Erfindung zunächst eine Trägerschicht, etwa scheibenförmig, bereitgestellt, auf der ein zur Ausbildung einer Mehrzahl von Strahlungsumlenkelementen vorgesehener Strahlungsumlenkstreifen und ein zur Ausbildung einer Mehrzahl von externen Spiegeln vorgesehener Spiegelstreifen angeordnet und vorzugsweise befestigt werden. Strahlungsumlenkstreifen und Spiegelstreifen werden, vorzugsweise vor der Befestigung, auf der Trägerschicht entsprechend einem optischen Resonator zueinander justiert. Der Verbund mit Trägerschicht, Strahlungsumlenk- und Spiegelstreifen kann nachfolgend in eine Mehrzahl von optischen Vorrichtungen mit einem Strahlungsumlenkelement und einem externen Spiegel vereinzelt werden. Der Träger der optischen Vorrichtung wird beim Vereinzeln aus der Trägerschicht, das Strahlungsumlenkelement aus dem Strahlungsumlenkstreifen und der externe Spiegel aus dem Spiegelstreifen gebildet.
Nichtlineare optische Elemente können ebenfalls in Form eines Streifens oder als Einzelelemente auf der Trägerschicht im Verbund oder als Einzelelemente auf dem Träger nach dem Vereinzeln angeordnet und/oder befestigt werden.

Eine optische Vorrichtung umfasst einen Träger, ein auf dem Träger angeordnetes Strahlungsumlenkelement und einen auf dem Träger angeordneten externen Spiegel, wobei die optische Vorrichtung als Resonatoraufsatz für ein Halbleiterlaserbauelement, insbesondere ein Halbleiterlaserbauelement der oben genannten Art, vorgesehen ist.
Eine derartige optische Vorrichtung, die als Aufsatz für einen Halbleiterlaserchip, der vorzugsweise auf einem Chipträger vormontiert ist, vorgesehen ist, erhöht mit Vorteil die Anzahl an Variationsmöglichkeiten hinsichtlich der Ausbildung des Resonators bzw. einer Frequenzkonversion bei gleichartigen Halbleiterlaserchips. Die

Halbleiterlaserchips können in effizienten automatisierten Prozessen auf Chipträgern vormontiert werden, woraufhin eine jeweils individualisierte optische Vorrichtung als Resonatoraufsatz auf dem Chipträger angeordnet und/oder befestigt werden kann. Insbesondere können mit gleichartigen Halbleiterlaserchips Halbleiterlaserbauelemente mit verschiedenen Wellenlängen der emittierten Strahlung, je nach jeweiligem nichtlinearen optischen Element ausgebildet werden.

Die weiter oben im Zusammenhang mit dem erfindungsgemäßen Halbleiterlaserbauelement beschriebenen Merkmale beziehen sich auch auf das erfindungsgemäße Verfahren oder die optische Vorrichtung oder umgekehrt, da die optische Vorrichtung bevorzugt für ein derartiges Halbleiterlaserbauelement vorgesehen ist oder nach dem Verfahren hergestellt wird.

Weitere Ausgestaltungen, Vorteile und Zweckmäßigkeiten der Erfindung, die in den Ansprüchen 1 und 25 definiert ist, ergeben sich aus der Beschreibung der folgenden Ausführungsbeispiele in Verbindung mit den Figuren. Dabei sind im folgenden "Ausführungsbeispiele" nur solche Beispiele, die alle in Anspruch 1 oder in Anspruch 25 definierten Merkmale enthalten. Wird der Begriff "Ausführungsbeispiel" in der folgenden Beschreibung für andere Beispiele verwendet, so bezeichnet er lediglich Beispiele, die für das Verstehen der Erfindung hilfreich sind.

Es zeigen:
Figur 1 ein erstes Ausführungsbeispiel eines erfindungsgemäßen Halbleiterlaserbauelements anhand einer schematischen Schnittansicht in Figur 1A und einer schematischen Aufsicht in Figur 1B,
Figur 2 ein zweites Ausführungsbeispiel eines erfindungsgemäßen Halbleiterlaserbauelements anhand einer schematischen Schnittansicht in Figur 2A und einer schematischen Aufsicht in Figur 2B,
Figur 3 ein drittes Ausführungsbeispiel eines erfindungsgemäßen Halbleiterlaserbauelements anhand einer schematischen Schnittansicht in Figur 3A und einer schematischen Aufsicht in Figur 3B,
Figur 4 ein viertes Ausführungsbeispiel eines erfindungsgemäßen Halbleiterlaserbauelements anhand einer schematischen Schnittansicht in Figur 4A und einer schematischen Aufsicht in Figur 4B,
Figur 5 ein fünftes Ausführungsbeispiel eines erfindungsgemäßen Halbleiterlaserbauelements anhand einer schematischen Schnittansicht in Figur 5A und einer schematischen Aufsicht in Figur 5B,
Figur 6 ein sechstes Ausführungsbeispiel eines erfindungsgemäßen Halbleiterlaserbauelements anhand einer schematischen Schnittansicht in Figur 6A und einer schematischen Aufsicht in Figur 6B,
Figur 7 eine schematische Schnittansicht eines siebten Ausführungsbeispiels eines erfindungsgemäßen Halbleiterlaserbauelements,
Figur 8 eine schematische Schnittansicht eines achten Ausführungsbeispiels eines erfindungsgemäßen Halbleiterlaserbauelements,
Figur 9 ein neuntes Ausführungsbeispiel eines erfindungsgemäßen Halbleiterlaserbauelements anhand einer schematischen Schnittansicht in Figur 9A und einer schematischen Aufsicht in Figur 9B,
Figur 10 eine schematische Schnittansicht eines zehnten Ausführungsbeispiels eines erfindungsgemäßen Halbleiterlaserbauelements,
Figur 11 eine schematische Schnittansicht eines elften Ausführungsbeispiels eines erfindungsgemäßen Halbleiterlaserbauelements,
Figur 12 eine schematische Schnittansicht eines zwölften Ausführungsbeispiels eines erfindungsgemäßen Halbleiterlaserbauelements,
Figur 13 eine schematische Schnittansicht eines Teils eines dreizehnten Ausführungsbeispiels eines erfindungsgemäßen Halbleiterlaserbauelements anhand schematischer Detailschnittansichten einer Variante in Figur 13A und einer Variante in Figur 13B,
Figur 14 eine schematische Schnittansicht eines vierzehnten Ausführungsbeispiels eines erfindungsgemäßen Halbleiterlaserbauelements und.
Figur 15 ein Ausführungsbeispiel eines erfindungsgemäßen Verfahrens zur Herstellung einer optischen Vorrichtung anhand einer schematischen Schnittansicht in Figur 15A und einer schematischen Aufsicht in Figur 15B.

Gleiche, gleichartige und gleich wirkende Elemente sind in den Figuren mit den gleichen Bezugszeichen versehen.

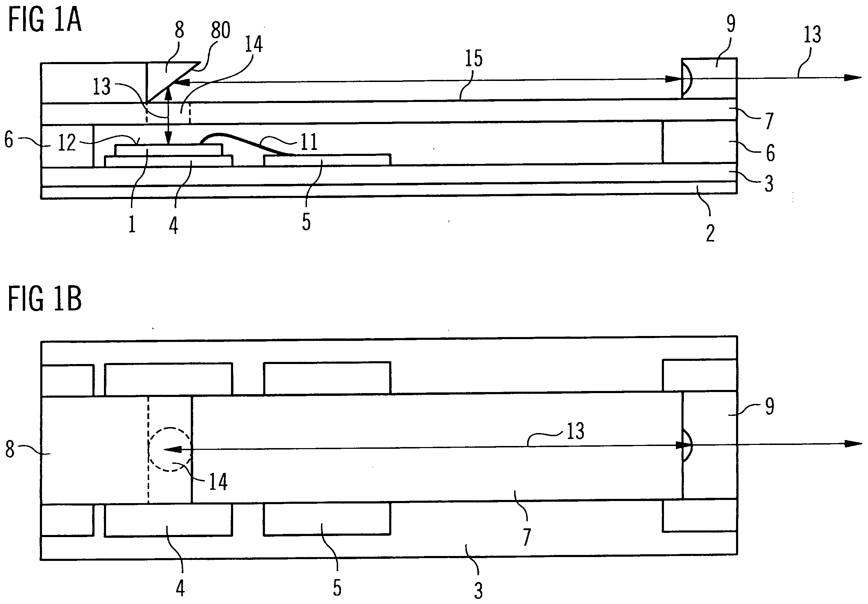

In Figur 1 ist ein erstes Ausführungsbeispiel eines erfindungsgemäßen Halbleiterlaserbauelements anhand einer Schnittansicht in Figur 1A und einer Aufsicht in Figur 1B schematisch dargestellt.

Ein Halbleiterlaserchip 1 ist auf einem Chipträger, der eine Wärmesenke 2, eine elektrische Isolationsschicht 3 sowie einen ersten Anschluss 4 und einen zweiten Anschluss 5 umfasst, angeordnet.

Dem Halbleiterlaserchip 1 in vertikaler Richtung nachgeordnet und mittels Beabstandungselementen 6 von dem Halbleiterlaserchip beabstandet, ist eine optische Vorrichtung, die einen Träger 7, ein auf der dem Halbleiterlaserchip 1 abgewandten Seite des Trägers angeordnetes Strahlungsumlenkelement 8 und einen auf der gleichen Seite des Trägers angeordneten externen Spiegel 9 umfasst.

Im Halbleiterlaserchip 1 ist zusammen mit einer oder mehreren Pumpstrahlungsquellen, etwa kantenemittierenden Lasern, die den Halbleiterlaserchip 1 lateral optisch pumpen, ein gepumpter aktiver Bereich monolithisch integriert. Zur elektrischen Kontaktierung der Pumpstrahlungsquelle(n) ist ein Bonddraht 11 mit dem zweiten Anschluss 5 elektrisch leitend verbunden und der Halbleiterlaserchip ist beispielsweise über eine Lotverbindung, etwa mittels eines Hartlots, auf dem ersten Anschluss 4 befestigt und elektrisch leitend mit diesem verbunden, wobei die Lotverbindung sowohl der Befestigung als auch der elektrisch leitenden Verbindung dient. Der Halbleiterlaserchip 1 ist auf dem Chipträger vormontiert.

Die Anschlüsse 4, 5 enthalten beispielsweise Kupfer und/oder gewährleisten eine ausreichende Wärmeableitung der am Halbleiterlaserchip im Betrieb erzeugten Wärme über die Isolationsschicht, welche beispielsweise eine Keramik, etwa Aluminiumnitrid, enthält zur Wärmesenke 2. Aluminiumnitrid zeichnet sich durch vorteilhaft hohe Wärmeleitfähigkeit aus. Die Wärmesenke 2 enthält zum Beispiel Kupfer. Der Chipträger ist somit bevorzugt als DBC-Substrat (DBC: Direct Bond Copper) ausgeführt.

Die Beabstandungselemente 6 können beispielsweise, ebenso wie der Träger 7, ein Glas oder Silizium enthalten oder daraus bestehen. Die Beabstandungselemente sind vorzugsweise vor dem Anordnen der optischen Vorrichtung auf dem Chipträger an dem Träger vormontiert oder durch Strukturierung des Trägers ausgeformt. Zur Vormontage eignen sich beispielsweise Beabstandungselemente aus Glas, die an dem Träger mittels anodischem Bonden, Kleben oder Löten befestigt sind. Zur Strukturierung der Beabstandungselemente aus dem Träger eignet sich besonders Sägen mit anschließendem Schleifen und Polieren der entsprechenden Oberflächen der Beabstandungselemente.

Das Strahlungsumlenkelement und/oder der externe Spiegel ist anodisch auf den Träger gebondet, geklebt oder gelötet. Die optische Vorrichtung ist vorzugsweise über die Beabstandungselemente auf dem Chipträger befestigt. Hierzu eignet sich beispielsweise Kleben oder Löten.

Die im Halbleiterlaserchip 1 mittels optischem Pumpen eines aktiven Bereichs des Halbleiterlaserchips erzeugte und vertikal zur Oberfläche 12 des Halbleiterlaserchips emittierte Strahlung 13 wird über das Strahlungsumlenkelement 8 nach dem Durchgang durch eine Aussparung 14 des Trägers 7 zu dem externen Spiegel 9 hin umgelenkt. Die Aussparung kann beispielsweise in den Träger eingeätzt oder gebohrt sein und ist vorzugsweise als Spalt oder wie in Figur 1B gezeigt in Aufsicht im wesentlichen kreisförmig ausgeführt.

Das Strahlungsumlenkelement 8 ist hier als Glasprisma ausgebildet, welches beispielsweise seitens einer Reflektorfläche 80 mit einer hochreflektierenden Beschichtung, etwa einer metallischen oder dielektrischen Beschichtung, für die vom Halbleiterlaserchip emittierte Strahlung versehen ist.

Der externe Spiegel begrenzt in einer bevorzugten Ausgestaltung der Erfindung zusammen mit einem weiteren Spiegel, der vorzugsweise als im Halbleiterlaserchip integrierter Bragg-Spiegel ausgebildet ist, den optischen Resonator des Halbleiterlaserbauelements. Bevorzugt weist der Bragg-Spiegel eine Reflektivität von 99,9%.

Im Ausführungsbeispiel gemäß Figur 1 ist der externe Spiegel als Auskoppelspiegel von Laserstrahlung aus dem Resonator ausgebildet und weist hierzu beispielsweise eine Reflektivität von 96 % oder mehr auf. Vorzugsweise ist der Spiegel konkav gekrümmt ausgeführt. Bevorzugt beträgt bei einer sphärischen Krümmung der Krümmungsradius des Spiegels 20 mm, besonders bevorzugt 10 mm, oder weniger, wodurch der Strahlradius der Strahlung im Resonator vorteilhaft gering gehalten werden kann.

Im Halbleiterlaserchip erzeugte Strahlung wird mittels induzierter Emission im aktiven Bereich des Halbleiterlaserchips verstärkt und teilweise über den externen Spiegel 9 ausgekoppelt. Über den Krümmungsradius des externen Spiegels und die optische Weglänge im Resonator kann der Strahlradius im Resonator an die Größe des aktiven Bereichs angepasst werden. Durch geeignete Anpassung des Strahlradius kann gegebenenfalls ein Grundmodenbetrieb des Halbleiterlaserbauelements erzwungen werden, beispielsweise, indem die Strahlquerschnittsfläche geeignet größer als der aktive Bereich eingestellt wird. Da Strahlungsanteile außerhalb des aktiven Bereichs nicht verstärkt werden, können höhere Moden somit nur entsprechend vermindert anschwingen. Das Strahlungsumlenkelement 8 lenkt die vom Halbleiterlaserchip aus auf das Strahlungsumlenkelement einfallende Strahlung in eine Richtung parallel zu einer Hauptfläche 15 des Trägers vorzugsweise zum externen Spiegel 9 hin um. Gemäß der Erfindung sind Träger und Halbleiterlaserchip so zueinander angeordnet, dass die vom Halbleiterlaserchip vertikal emittierte Strahlung im wesentlichen senkrecht zur lateralen Haupterstreckungsrichtung bzw. Hauptfläche des Trägers abgestrahlt wird und vom Strahlungsumlenkelement in eine Richtung parallel zur Hauptfläche, vorzugsweise parallel zur Haupterstreckungsrichtung, des Trägers umgelenkt wird. Bevorzugt sind hierzu die Oberfläche 12 des Halbleiterlaserchips und der Träger im wesentlichen parallel zueinander angeordnet. Besonders bevorzugt ist die Hauptfläche 15 des Trägers 7 im wesentlichen parallel zur Oberfläche 12 des Halbleiterlaserchips 1 und/oder der Halbleiterlaserchip 1 ist derart auf dem Chipträger vormontiert, dass die Oberfläche 12 im Wesentlichen parallel zum Chipträger verläuft.

Weiterhin lenkt das Strahlungsumlenkelement die einfallende Strahlung bevorzugt um einen Winkel von 90° um und ist hierzu beispielsweise derart ausgebildet, dass die Reflektorfläche 80 mit der Hauptfläche 15 des Trägers einen Winkel von ungefähr 45° einschließt.

Über die Faltung des Resonators am Strahlungsumlenkelement 8 wird die Ausbildung einer kompakten Bauform des Halbleiterlaserbauelements und des Resonators erleichtert.

Da die optische Vorrichtung vorzugsweise vorgefertigt vorliegt sowie Strahlungsumlenkelement und externer Spiegel schon dementsprechend einem Resonator aufeinander abgestimmt sind, ist eine Justage des externen Spiegels für den optischen Resonator nur bezüglich des Halbleiterlaserchips erforderlich. Die optische Vorrichtung kann einem vormontierten Halbleiterlaserchip als Resonatoraufsatz aufgesetzt und auf dem Chipträger befestigt werden. Eine Justage des externen Spiegels relativ zum Halbleiterlaserchip kann mit Vorteil in der Montageebene der optischen Vorrichtung, vorzugsweise der Ebene des Chipträgers, erfolgen. Auf eine aufwendige dreidimensionale Justage des Spiegels im Raum kann mit Vorteil verzichtet werden.

In einer weiteren bevorzugten Ausgestaltung der Erfindung ist der Halbleiterlaserchip gemäß einem Halbleiterscheibenlaser oder VECSEL ausgebildet. Die Wellenlänge der im Halbleiterlaserchip erzeugten Strahlung liegt besonders bevorzugt im infraroten Spektralbereich, beispielsweise zwischen einschließlich 900 nm und einschließlich 1100 nm, und kann etwa 920 nm, 1000 nm oder 1040 nm betragen. Der Halbleiterlaserchip basiert hierfür mit Vorzug auf GaAs oder AlGaAs.

In einer vorteilhaften Weiterbildung der Erfindung enthält oder basiert der Halbleiterlaserchip auf einem III-V-Halbleitermaterialsystem, etwa Inₓ Gay Al_{1-x-y} P, Inₓ Gay Al_{1-x-y} N oder Inₓ Ga_{y} Al_{1-x-y} As, jeweils mit 0≤x≤1, 0≤y≤1 und x+y≤1. Zur effizienten Strahlungserzeugung im infraroten Spektralbereich sind Materialien aus dem Materialsystem Inₓ Ga_{y} Al_{1-x-y} As besonders geeignet.

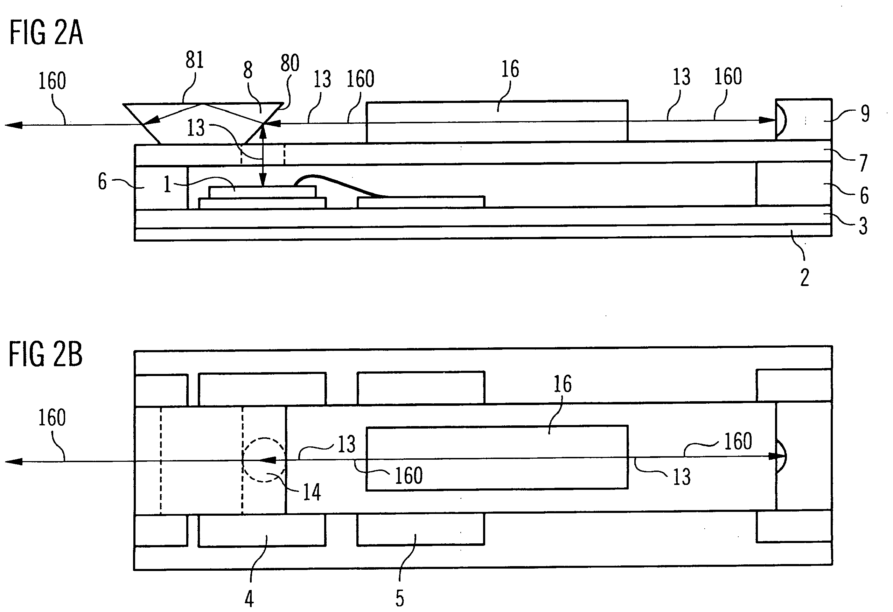

In Figur 2 ist ein zweites Ausführungsbeispiel eines erfindungsgemäßen Halbleiterlaserbauelements anhand einer Schnittansicht in Figur 2A und einer Aufsicht in Figur 2B schematisch dargestellt.

Im Wesentlichen entspricht dieses Ausführungsbeispiel dem in Figur 1 gezeigten Ausführungsbeispiel. Im Unterschied hierzu ist gemäß Figur 2 ein nichtlineares optisches Element 16 zur Frequenzkonversion im optischen Resonator angeordnet und die Auskopplung erfolgt durch das Strahlungsumlenkelement.

Im Halbleiterlaserchip erzeugte oder verstärkte Strahlung 13 trifft auf das Strahlungsumlenkelement 8, das etwa über entsprechende Beschichtung der Reflektorfläche 80, hochreflektierend für die Strahlung 13 ausgebildet ist, wird an der Reflektorfläche 80 umgelenkt und durchläuft das nichtlineare optische Element 16, in dem ein Teil der Strahlung 13 in frequenzkonvertierte Strahlung 160 umgewandelt wird. Nach dem Durchgang durch das nichtlineare optische Element treffen die nicht konvertierte Strahlung 13 und die frequenzkonvertierte Strahlung 160 auf den externen Spiegel 9, der vorzugsweise für beide Strahlungen 13, 160 hochreflektiv - zum Beispiel mit einer Reflektivität von 99,9% oder mehr - und im Gegensatz zur Figur 1 nicht zur Auskopplung ausgebildet ist. Am externen Spiegel 9 werden die Strahlung 13 und die frequenzkonvertierte Strahlung 160 in Richtung des Strahlungsumlenkelements rückreflektiert und durchlaufen ein weiteres Mal das nichtlineare optische Element, wobei ein weiterer Anteil der Strahlung 13 in der Frequenz konvertiert wird.

Nach dem erneuten Durchgang durch das nichtlineare optische Element 16 treffen die Strahlung 13 und die konvertierte Strahlung 160 auf das Strahlungsumlenkelement 8, das hochreflektiv für die Strahlung 13 und hochtransmittiv für die frequenzkonvertierte Strahlung 160 ausgebildet ist. Hierzu ist die Reflektorfläche 80 vorzugsweise entsprechend beschichtet. Die Strahlung 13 wird so dem Halbleiterlaserchip 1 zur weiteren Verstärkung zugeführt und die frequenzkonvertierte Strahlung 160 über das Strahlungsumlenkelement aus dem Resonator ausgekoppelt. Vorzugsweise wird die frequenzkonvertierte Strahlung derart ausgekoppelt, dass sie im Wesentlichen parallel zur Haupterstreckungsrichtung des Trägers abgestrahlt wird.

Das Strahlungsumlenkelement ist hierbei als Prisma ausgeführt. Bei der Strahlungsauskopplung wird die Strahlung 160 an der dem Träger abgewandten Oberfläche 81 des Strahlungsumlenkelements intern total reflektiert und auf der dem nichtlinearen optischen Element abgewandten Seite des Strahlungsumlenkelements aus dem Resonator ausgekoppelt. Das Strahlungsumlenkelement ist für eine effiziente Totalreflexion seitens der Oberfläche 81 vorzugsweise entsprechend glatt poliert.

Das nichtlineare optische Element 16 ist beispielsweise zur Frequenzverdopplung (SHG) der im Halbleiterlaserchip verstärkten Strahlung ausgebildet. Beispielsweise erzeugt das nichtlineare optische Element aus infraroter Strahlung-grüne oder blaue Strahlung. Strahlung der Wellenlänge 920 nm kann etwa in Strahlung einer Wellenlänge von 460 nm konvertiert werden. Vorzugsweise ist das nichtlineare optische Element auf dem Träger, beispielsweise mittels Kleben oder Löten, befestigt.

Ein zur Frequenzverdopplung, insbesondere zur Erzeugung blauen oder grünen Lichts, geeignetes nichtlineares optisches Element kann zum Beispiel einen nichtlinearen Kristall, etwa einen LBO (z.B. Lithiumtriborat) oder einen BiBO (z.B. Wismuthtriborat) Kristall umfassen.

Das nichtlineare optische Element kann ferner-periodisch gepolte (PP: Periodically Poled) quasi phasen-angepasste (QPM: Quasi Phase Matching) Strukturen, etwa PP-KTP (z.B. KTiOPO₄), PP-LN (z.B. PP-LiNbO₃) oder PP-LT (z.B. PP-LiTaO₃) aufweisen.

PP-QPM-Strukturen können gegebenenfalls auch in MgO-dotierten oder weiteren, von den oben angeführten verschiedenen, stöchiometrischen Materialvarianten, eingesetzt werden. Insbesondere können auch von den oben angeführten abweichende stöchiometrische Materialvarianten, etwa von LiNbO₃ und LiTaO₃ abweichende Varianten, eingesetzt werden.

Durch Verwendung von QPM-Materialien können doppelbrechungsbedingte Effekte wie beispielsweise ein Walk-Off (Abweichung der Austrittsrichtung frequenzkonvertierter Strahlung aus dem nichtlinearen optischen Element von der Eintrittsrichtung der Strahlung in das Element) mit Vorteil verringert werden.

QPM-Materialien zeichnen sich weiterhin durch hohe Effizienz bei der Frequenzkonversion auch bei einer vergleichsweise hohen Strahltaille der Strahlung im nichtlinearen optischen Element aus. Bei der Frequenzkonversion in Kristallen ist die Effizienz oftmals stark von der Strahltaille beeinflusst und nimmt gewöhnlich mit wachsender Strahltaille ab. Zur Effizienzsteigerung in Kristallen kann die zu konvertierende Strahlung auf den Kristall über ein optisches Element fokussiert werden. Von einer derartigen Fokussierung kann jedoch bei QPM-Materialien wegen der erhöhten materialbezogenen Effizienz abgesehen werden. Weiterhin kann eine Mehrzahl von PP-QPM-Strukturen mit Vorteil vereinfacht gleichzeitig im Scheibenverbund hergestellt werden.

Durch eine geeignete periodische Polung ist ein derartiges nichtlineares optisches Element mit Vorteil vereinfacht an die spezifischen Eigenschaften des Halbleiterlaserchips anpassbar. Insbesondere kann die spektrale und/oder thermische Akzeptanzbreite der Frequenzkonversion eines derartigen nichtlinearen optischen Elements auf den Halbleiterlaserchip bzw. die von diesem erzeugte Strahlung angepasst werden.

Gegebenenfalls kann auch eine aperiodisch gepolte QPM-Struktur als nichtlineares optisches Element zur Frequenzkonversion eingesetzt werden. Diese Strukturen zeichnen sich gegenüber periodisch gepolten Strukturen oftmals durch erhöhte spektrale Akzeptanz aus, so dass bei leichten, etwa temperaturbedingten, Schwankungen der Frequenz der zu konvertierenden Strahlung die Gefahr einer Effizienzminderung der Frequenzkonversion im nichtlinearen optischen Element nicht maßgeblich erhöht wird.

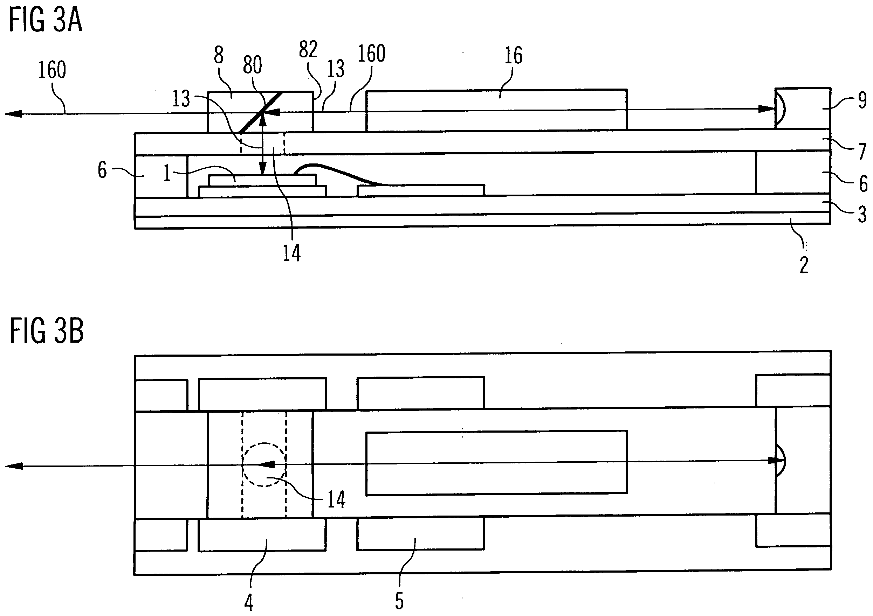

Im Unterschied zu Figur 2 ist im dritten Ausführungsbeispiel, das in Figur 3 anhand einer Schnittansicht in Figur 3A und einer Aufsicht in Figur 3B schematisch dargestellt ist, das Strahlungsumlenkelement 8 als Strahlteiler ausgeführt. Vorzugsweise ist der Strahlteiler als dichroitischer Strahlteiler ausgebildet.

Seitens der Oberfläche 82 ist der Strahlteiler vorzugsweise mit einer Antireflexbeschichtung für die Strahlung 13 und die frequenzkonvertierte Strahlung 160 beschichtet, wohingegen an der Reflektorfläche 80, die an der Koppelfläche des Strahlteilers ausgebildet ist, die Strahlung 13 in Richtung des Halbleiterlaserchips reflektiert und die frequenzkonvertierte Strahlung 160 transmittiert wird. Dies kann beispielsweise über entsprechend hochreflektive oder hochtransmittive Beschichtungen seitens der Reflektorfläche 80 des Strahlteilers erreicht werden. Seitens der dem Halbleiterlaserchip zugewandten Oberfläche oder der der Oberfläche 82 gegenüberliegenden Oberfläche ist der Strahlteiler vorzugsweise für die entsprechenden Strahlungen mit einer Antireflexbeschichtung versehen.

Im Gegensatz zu den in den Figuren 1 und 2 gezeigten Ausführungsbeispielen wird das Strahlungsumlenkelement in Figur 3 von der frequenzkonvertierten 160 und der nicht frequenzkonvertierten Strahlung 13 durchstrahlt, wobei die Strahlungseintrittseiten gleich, die Strahlungsaustrittsseiten jedoch verschieden sind. Weiterhin ist die Aussparung 14 vorzugsweise vollständig vom Strahlungsumlenkelement 8 überdeckt.

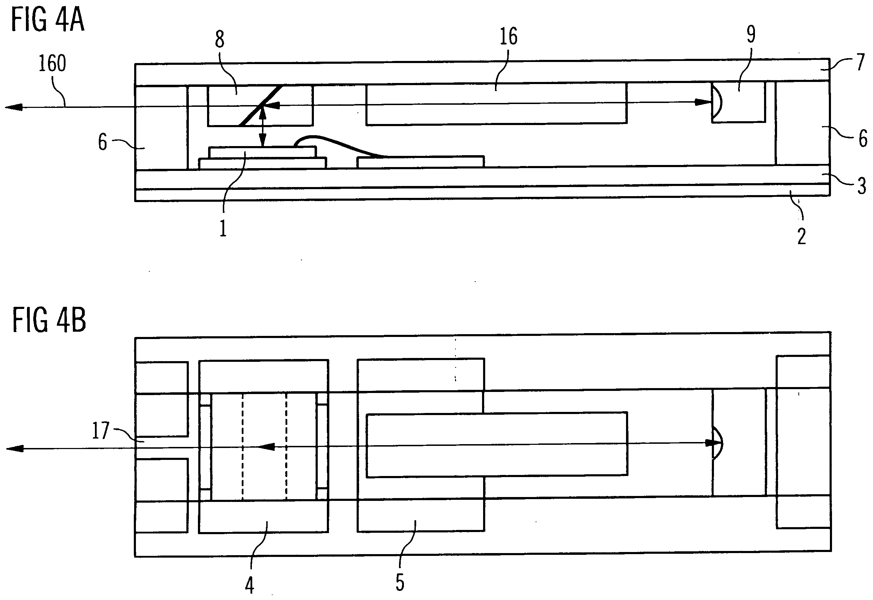

In Figur 4 ist ein viertes Ausführungsbeispiel eines erfindungsgemäßen Halbleiterlaserbauelements anhand einer Schnittansicht in Figur 4A und einer Aufsicht in Figur 4B schematisch dargestellt.

Im Unterschied zu Figur 3 sind das Strahlungsumlenkelement 8, das nichtlineare optische Element 16 und der externe Spiegel 9 auf der dem Halbleiterlaserchip zugewandten Seite des Trägers 7 angeordnet.

Die Strahlungsauskopplung aus dem Resonator erfolgt über das Strahlungsumlenkelement 8. Die Strahlung tritt aus dem Halbleiterlaserbauelement vorzugsweise über den Bereich der Beabstäridungselemente 6, in dem zweckmäßigerweise ein Fenster 17 zur Strahlungsauskopplung vorgesehen ist.

Durch die Anordnung der Resonatorelemente und des nichtlinearen optischen Elements auf der dem Halbleiterlaserchip 1 zugewandten Seite des Trägers wird die Ausbildung einer kleineren und kompakteren Bauform verglichen mit den in den vorhergehenden Figuren dargestellten Ausführungsbeispielen erleichtert.

Weiterhin kann auf eine Aussparung im Träger verzichtet werden, wodurch der Schutz des Halbleiterlaserchips vor schädlichen äußeren Einflüssen vorteilhaft erhöht wird.

Das Beabstandungselement 6 kann beispielsweise Silizium, ein Glas oder eine Keramik enthalten oder daraus bestehen. Das Fenster 17 ist vorzugsweise als Aussparung mittels Bohren, Ätzen oder Sägen in das Beabstandungselement 6 eingebracht.

Das Fenster ist mit Vorzug als Bohrung, eingeätztes Loch, oder eingesägter Spalt in einem Beabstandungselement oder als Zwischenraum zwischen zwei benachbarten Beabstandungselementen ausgebildet.

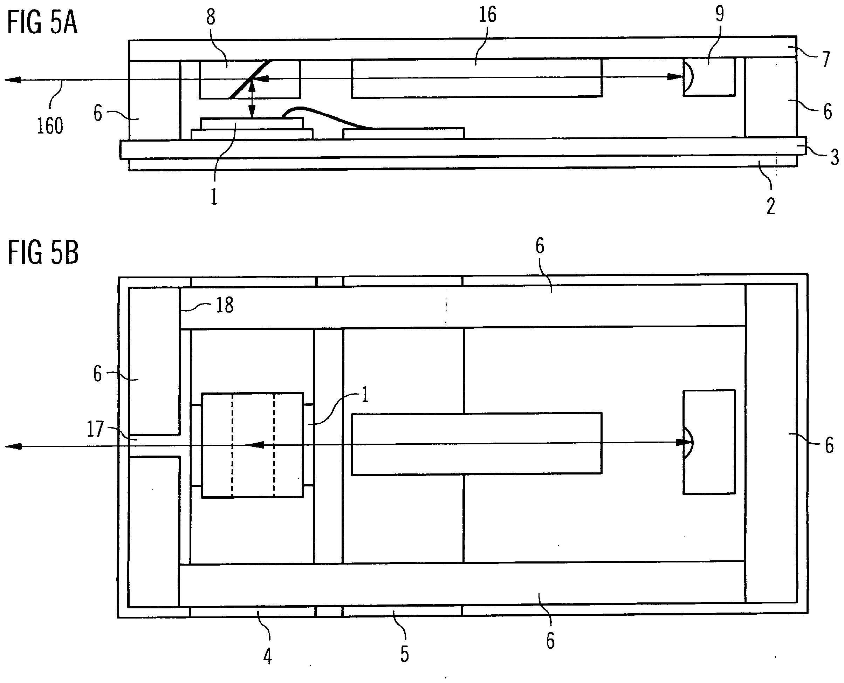

Ein fünftes Ausführungsbeispiel eines erfindungsgemäßen Halbleiterlaserbauelements ist in Figur 5 anhand einer Schnittansicht in Figur 5A und einer Aufsicht in Figur 5B schematisch dargestellt und unterscheidet sich von dem in Figur 4 dargestellten Ausführungsbeispiel im wesentlichen darin, dass die optische Vorrichtung als Gehäuseteil für ein Gehäuse des Halbleiterlaserbauelements ausgebildet ist.

Der Träger 7 ist hierbei als Gehäusedeckel und die Beabstandungselemente 6 sind als Gehäusewandung ausgebildet. Der Träger überspannt den Halbleiterlaserchip vorzugsweise vollständig und ragt noch über den Halbleiterlaserchip hinaus.

Die Beabstandungselemente 6 umlaufen den Halbleiterlaserchip 1 vorzugsweise allseitig, wie in Figur 5B dargestellt ist. Dadurch wird der Schutz des Halbleiterlaserchips vor schädlichen äußeren Einflüssen vorteilhaft erhöht.

Hierbei können das Strahlungsumlenkelement 8, das nichtlineare optische Element 16 und der externe Spiegel 9 auf der dem Halbleiterlaserchip zugewandten Seite des Trägers 7, etwa wie in Figur 5A, oder auf der dem Halbleiterlaserchip abgewandten Seite des Trägers, etwa entsprechend der Figur 2, angeordnet sein.

Im ersteren-Fall erfolgt die Auskopplung von Strahlung aus dem Resonator vorzugsweise durch ein Fenster 17, das in einem Beabstandungselement oder zwischen zwei Beabstandungselementen ausgebildet sein kann.

Im letzteren Fall kann z.B. wie in Figur 2 eine Aussparung im Träger vorgesehen sein und Strahlung auf der dem Halbleiterlaserchip abgewandten Seite aus dem Resonator ausgekoppelt werden.

Eventuell zwischen zwei Beabstandungselementen vorhandene Spalte, die nicht als Fenster dienen, wie ein Spalt 18, können zum weitergehenden Schutz gegen Feuchtigkeit oder Staub mit einem Dichtungsmittel, zum Beispiel einem Klebstoff, abgedichtet werden.

In einer bevorzugten Ausgestaltung der Erfindung sind die Beabstandungselemente 6 aus dem Träger, beispielsweise über Sandstrahlen oder Ätzen, herausstrukturiert. Träger und Beabstandungselemente können somit in einer einstückigen Struktur ausgebildet sein. Die Anzahl an Spalten zwischen Beabstandungselementen kann so verringert werden.

Mit Vorzug ist das Beabstandungselement einstückig und spaltfrei ausgebildet. Insbesondere kann in den Träger eine Kavität für den Halbleiterlaserchip strukturiert sein. Hierdurch kann eine im wesentlichen hermetische Abdichtung des Gehäuses, zum Beispiel gegen Staub oder Feuchtigkeit, erleichtert werden.

Das Gehäuse des Halbleiterlaserbauelements umfasst den Chipträger, die Beabstandungselemente 6 und den Träger 7, wobei der Träger 7 den Gehäusedeckel, die Beabstandungselemente die Gehäusewandung und der Chipträger den Gehäuseboden des Halbleiterlaserbauelements bilden. Die laterale Ausdehnung des Trägers ist für die Ausbildung als Gehäusedeckel vorzugsweise an die des Chipträgers angepasst. Die Ausbildung einer vergleichsweise ebenen Oberfläche des Halbleiterlaserbauelements wird so erleichtert.

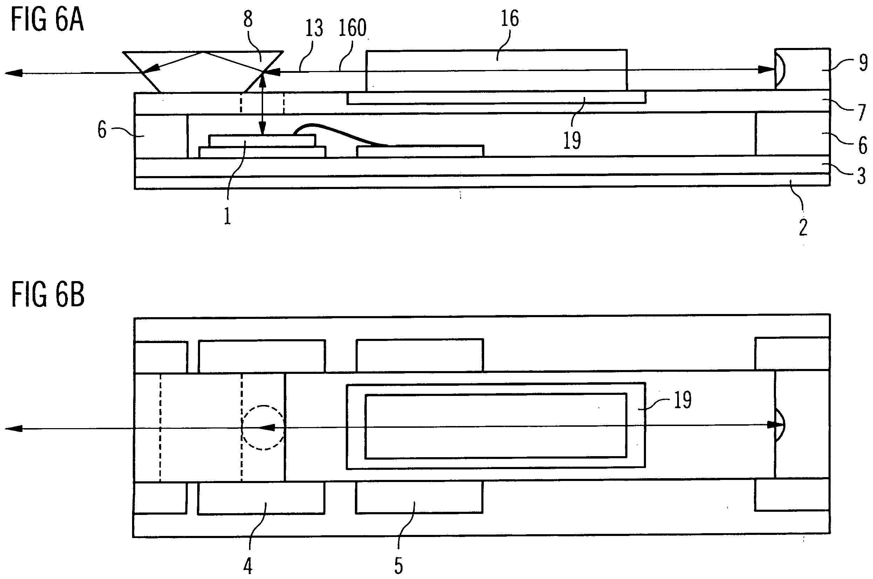

Das in Figur 6 anhand einer Schnittansicht in Figur 6A und einer Aufsicht in Figur 6B schematisch dargestellte sechste Ausführungsbeispiel eines erfindungsgemäßen Halbleiterlaserbauelements entspricht im Wesentlichen dem in Figur 2 dargestellten Ausführungsbeispiel. Im Unterschied zu dem in Figur 2 dargestellten Ausführungsbeispiel ist ein Temperierungselement 19 zur Temperierung des nichtlinearen optischen Elements vorgesehen. Das Temperierungselement 19 ist bevorzugt thermisch leitend mit dem nichtlinearen optischen Element verbunden, unterhalb des nichtlinearen optischen Elements angeordnet und/oder grenzt direkt an das nichtlineare optische Element.

Das Temperierungselement 19 ist im vorliegenden Ausführungsbeispiel als Heizwiderstand im Träger 7 integriert. Zeckmäßigerweise enthält hierzu der Träger ein Halbleitermaterial, etwa Silizium, und das Temperierungselement ist mittels geeigneter Dotierung als pn-Übergang ausgeführt, der als Heizwiderstand betrieben werden kann. Für einen pn-Übergang werden beispielsweise Oberflächenbereiche des Trägers entsprechend dotiert.

Alternativ oder zusätzlich kann ein externes, nicht im Träger integriertes Temperierungselement, das vorzugsweise zwischen dem Träger und dem nichtlinearen optischen Element angeordnet ist, vorgesehen sein. Ein Metalldünnschichtwiderstand, etwa Pt enthaltend, ist hierfür besonders geeignet.

Aufgrund einer Temperaturabhängigkeit des Brechungsindizes können Temperaturschwankungen des nichtlinearen optischen Elements zu Schwankungen in der Frequenz der frequenzkonvertierten Strahlung 160 führen. Die Gefahr derartiger Schwankungen kann über eine Temperierung des nichtlinearen optischen Elements mittels des Temperierungselements 19 verringert werden.

Das Temperierungselement 19 kann sowohl auf der dem nichtlinearen optischen Element zugewandten Seite des Trägers als auch auf der dem nichtlinearen optischen Element abgewandten Seite des Trägers angeordnet sein. Letzteres ist insbesondere dann von Vorteil, wenn das nichtlineare optische Element, etwa wie in den Figuren 4 oder 5, auf der dem Halbleiterlaserchip zugewandten Seite des Trägers angeordnet ist. Eine elektrische Ansteuerung des Temperierungselements im Betrieb des Halbleiterlaserbauelements kann so erleichtert werden.

In einer vorteilhaften Weiterbildung der Erfindung beträgt der Abstand, insbesondere der optische Weg, zwischen Halbleiterlaserchip und Strahlungsumlenkelement, insbesondere zur Reflektorfläche 80, ungefähr 2 mm, der Abstand vom Strahlungsumlenkelement zu der dem Strahlungsumlenkelement zugewandten Oberfläche des nichtlinearen optischen Elements 1,0 mm und der Abstand zwischen der dem externen Spiegel zugewandten Oberfläche des nichtlinearen optischen Elements und dem externen Spiegel ungefähr 0,5 mm.

Vorteilhafte Ausdehnungen des nichtlinearen optischen Elements sind beispielsweise 4 mm für einen Kristall mit kritischer Phasenanpassung, etwa BiBo, oder 3 mm für eine PP-QPM-Struktur, etwa PP-LN.

Ist der Endspiegel in einem derartigen Resonator mit einem Radius von 20 mm sphärisch konkav gekrümmt, so ergeben sich für den Strahlradius im Resonator ungefähr folgende Werte: 53 µm am Halbleiterlaserchip, 55 µm am Strahlungsumlenkelement, 56 µm an der dem Strahlungsumlenkelement zugewandten Seite des nichtlinearen optischen Elements, 62 µm an der dem externen Spiegel zugewandten Oberfläche des nichtlinearen optischen Elements und 63 µm am externen Spiegel.

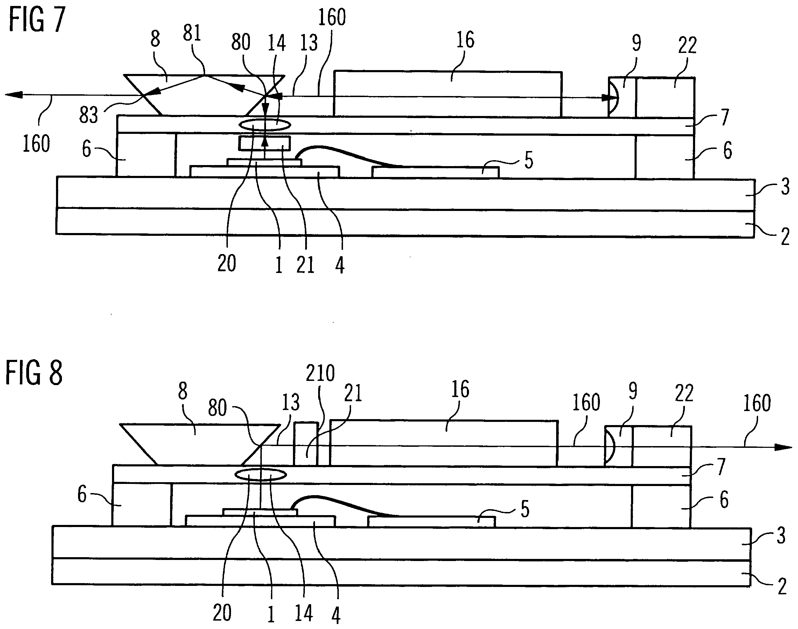

Das in Figur 7 anhand einer Schnittansicht schematisch dargestellte siebte Ausführungsbeispiel eines erfindungsgemäßen Halbleiterlaserbauelements entspricht im Wesentlichen dem in Figur 2 gezeigten. Im Unterschied hierzu sind im Strahlengang im Resonator ein optisches Element 20 zur Strahlformung und ein Wellenlängenfilter 21 angeordnet. Weiterhin ist der externe Spiegel 9 an einem Halterungselement 22 befestigt.

Das optische Element 20 ist vorzugsweise am Träger 7 angeordnet und dort befestigt. Beispielsweise ist das optische Element im Strahlengang im Resonator auf der dem Halbleiterlaserchip abgewandten oder der diesem zugewandten Seite des Trägers angeordnet. Vorzugsweise ist das optische Element in der Aussparung 14 angeordnet.

Der Wellenlängenfilter 21 ist auf der dem Halbleiterlaserchip 1 zugewandten Seite des Trägers angeordnet und vorzugsweise am Träger befestigt. Das optische Element 20 ist mit Vorzug zur Verringerung der Strahltaille der zu konvertierenden Strahlung 13 ausgebildet. Über Fokussierung im Bereich des nichtlinearen optischen Elements kann eine besonders effiziente Frequenzkonversion im nichtlinearen optischen Element, insbesondere in einem nichtlinearen, doppelbrechenden Kristall, erreicht werden.

Die Effizienz der Frequenzkonversion kann weiterhin erhöht werden, indem über den Wellenlängenfilter 21 die spektrale Breite des Spektrums der zu konvertierenden Strahlung, vorzugsweise infraroter Strahlung, verringert wird.

Das optische Element kann beispielsweise als Linse, insbesondere mit einem Fokus, etwa als herkömmliche Sammellinse oder als GRIN-(GRadienten INdex), Fresnel-, oder diffraktive Linse ausgebildet sein.

Eine Hauptebene der Linse oder des Wellenlängenfilters kann parallel zur lateralen Haupterstreckungsrichtung des Trägers oder senkrecht zu dieser angeordnet sein.

Der Wellenlängenfilter 21 zur Wellenlängenselektion kann beispielsweise als dielektrischer Filter, als doppelbrechender Filter oder als Etalon ausgeführt sein. Alternativ kann eine wellenlängenselektive Wirkung gegebenenfalls auch durch eine entsprechende, vorzugsweise einseitige und/oder dielektrische, Beschichtung des optischen Elements 20 erzielt werden.

Der externe Spiegel 9 ist als Resonatorendspiegel nicht zur Auskopplung von Strahlung vorgesehen und zweckmäßigerweise hochreflektiv für die Strahlung 13 und die frequenzkonvertierte Strahlung 160 ausgebildet. Das Strahlungsumlenkelement 8 ist seitens der Reflektorfläche 80 hochtransmittiv für die frequenzkonvertierte Strahlung 160 und hochreflektiv für die Strahlung 13 ausgebildet. Das optische Element 20 und der Wellenlängenfilter 21 sind vorzugsweise hochtransmittiv für die Strahlung 13 ausgebildet. Diese Reflexions- und Transmissionseigenschaften können über geeignete Beschichtungen der relevanten Oberflächen des externen Spiegels, des Strahlungsumlenkelements, des optischen Elements und/oder des Wellenlängenfilters erzielt werden.

Der externe Spiegel 9 kann beispielsweise im Wesentlichen plan oder konkav ausgeführt sein. Dies ist über die gestrichelte Linie beim externen Spiegel 9, die einen konkaven externen Spiegel andeutet, schematisch dargestellt. Eine plane Ausführung wird durch die Strahlformung über das optische Element 20 erleichtert, da der Strahlradius durch das optische Element vorteilhaft gering gehalten wird und auf eine Strahlformung durch den externen Spiegel verzichtet werden kann.

Das anhand einer Schnittansicht in Figur 8 schematisch dargestellte achte Ausführungsbeispiel eines erfindungsgemäßen Halbleiterlaserbauelements entspricht im Wesentlichen dem in Figur 7 dargestellten Ausführungsbeispiel. Im Unterschied hierzu ist der Wellenlängenfilter 21 auf der dem Halbleiterlaserchip 1 abgewandten Seite des Trägers 7 angeordnet. Weiterhin erfolgt im Unterschied zu Figur 7 die Strahlungsauskopplung nicht durch das Strahlungsumlenkelement 8, sondern durch den externen Spiegel 9.

Der externe Spiegel ist hierzu hochreflektiv für die Strahlung 13 und hochtransmittiv für die Strahlung 160 ausgebildet. Die Reflektorfläche 80 des Strahlungsumlenkelements 8 ist reflektierend bezüglich der Strahlung 13 ausgebildet. Eine Oberfläche des Wellenlängenfilters 21, vorzugsweise die dem nichtlinearen optischen Element zugewandte Oberfläche 210, ist bezüglich der frequenzkonvertierten Strahlung 160 hochreflektiv und hochtransmittiv für die Strahlung 13 ausgebildet, sodass der Anteil der über den externen Spiegel 9 ausgekoppelten frequenzkonvertierten Strahlung 160 aufgrund der Reflexion am Wellenlängenfilter vorteilhaft erhöht ist. Zweckmäßigerweise ist der Wellenlängenfilter mit einer Reflexionsbeschichtung für die Strahlung 160 bzw. einer Antireflexbeschichtung für die Strahlung 13 versehen.

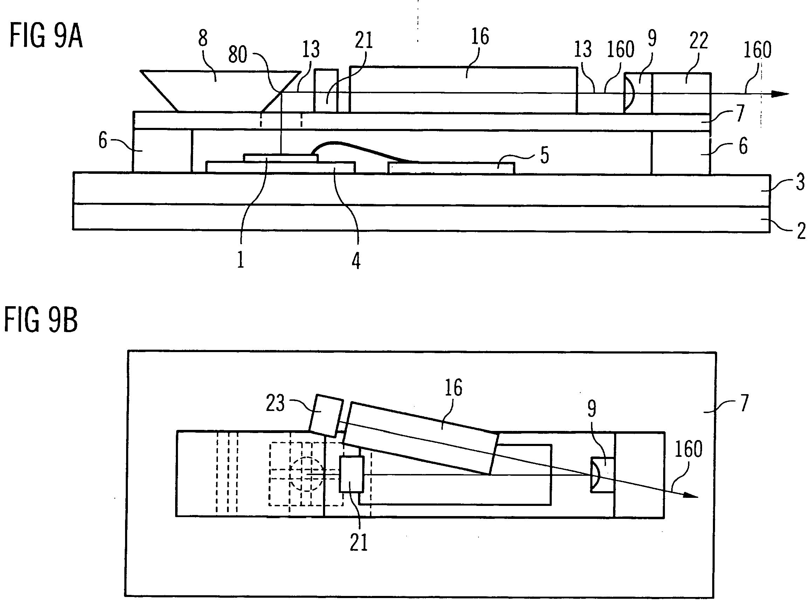

Das in Figur 9 anhand einer Schnittansicht in Figur 9A und einer Aufsicht in Figur 9B schematisch dargestellte neunte Ausführungsbeispiel eines erfindungsgemäßen Halbleiterlaserbauelements entspricht im Wesentlichen dem in Figur 8 gezeigten Ausführungsbeispiel. Im Unterschied hierzu ist auf das optische Element 20 zur Strahlformung verzichtet.

Zur Strahlformung ist in diesem Ausführungsbeispiel eine weitere Faltung des Resonators vorgesehen. Hiermit kann auch ein hinreichend geringer Strahlradius zur effizienten Frequenzkonversion im nichtlinearen optischen Element 16 erzielt werden.

Der externe Spiegel 9 ist zweckmäßigerweise zur Verringerung der Strahltaille konkav gekrümmt und zugleich als Auskoppelspiegel und Faltungsspiegel ausgebildet. Der Resonator wird durch einen weiteren externen Spiegel 23, der vorzugsweise auf dem Träger 7 angeordnet und/oder konkav gekrümmt ist, begrenzt. Das nichtlineare optische Element ist im Strahlengang zwischen den Spiegeln 9 und 23 angeordnet.

Der Spiegel 23 ist zweckmäßigerweise hochreflektierend für die Strahlungen 160 und 13 ausgebildet. Die Emissionsrichtung weicht aufgrund der weiteren Faltung des Resonators von der Richtung der vom Strahlungsumlenkelement in Richtung des externen Spiegels 9 gelenkten Strahlung ab. Mit Vorteil kann die weitere Faltung im Wesentlichen in der Ebene parallel zum Träger 7 erfolgen. Durch eine derartige Faltung in der Ebene parallel zum Träger kann das Halbleiterlaserbauelement gegebenenfalls verglichen mit den weiter oben beschriebenen Ausführungsbeispielen kompakter und kleiner ausgeführt werden.

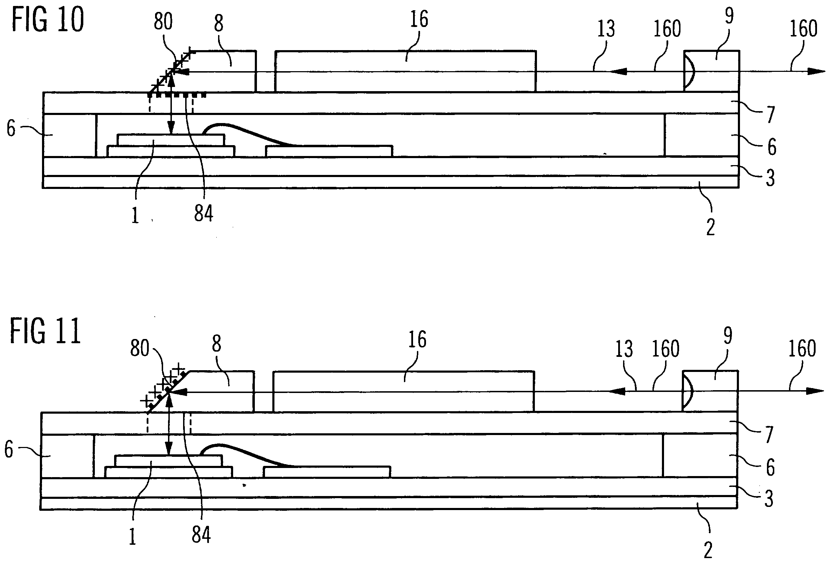

Das in Figur 10 anhand einer Schnittansicht schematisch dargestellte zehnte Ausführungsbeispiel eines erfindungsgemäßen Halbleiterlaserbauelements entspricht im Wesentlichen dem in Figur 1 dargestellten. Im Unterschied hierzu ist ein nichtlineares optisches Element 16 vorgesehen, und das Strahlungsumlenkelement wird vor der Reflexion an der Reflektorfläche 80 teilweise durchstrahlt. Die frequenzkonvertierte Strahlung 160 wird über den externen Spiegel 9 aus dem Resonator ausgekoppelt. Auf einer Oberfläche 84 des Strahlungsumlenkelements kann eine, in Figur 10 gepunktet angedeutete, wellenlängenselektive, vorzugsweise dielektrische, Beschichtung, aufgebracht sein. Die Reflexion an der Reflektorfläche 80 kann unter interner Totalreflexion oder mittels einer geeigneten hochreflektiven Beschichtung erzielt werden. Eine derartige Beschichtung ist in Figur 10 gekreuzt angedeutet.

Im Unterschied hierzu ist in dem in Figur 11 anhand einer Schnittansicht schematisch dargestellten elften Ausführungsbeispiel eines erfindungsgemäßen Halbleiterlaserbauelements die wellenlängenselektive Beschichtung seitens der Reflektorfläche 80 auf dem Strahlungsumlenkelement 8 aufgebracht.

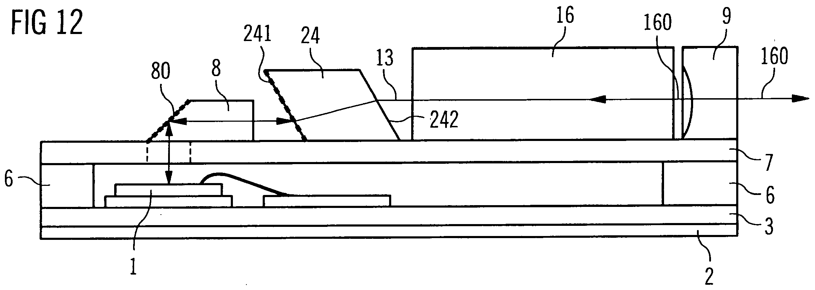

Das in Figur 12 anhand einer Schnittansicht schematisch dargestellte zwölfte Ausführungsbeispiel eines erfindungsgemäßen Halbleiterlaserbauelements entspricht im Wesentlichen dem in Figur 11 gezeigten. Im Unterschied zu Figur 11 ist zwischen Strahlungsumlenkelement 8 und nichtlinearem optischen Element 16 ein Wellenlängenselektionselement 24 zur Wellenlängenselektion, etwa ein Prisma, auf dem Träger angeordnet.

Eine Wellenlängenselektion kann beispielsweise über eine entsprechende Beschichtung einer Oberfläche des Wellenlängenselektionselements 24 oder durch Dispersion erzielt werden. Über die Wellenlängenabhängigkeit des Brechungsindexes können beim Strahlungsdurchgang durch das Wellenlängenselektionselement 24 Verluste für gewisse Moden im Resonator derart erhöht werden, dass diese im Halbleiterlaserchip nicht mehr verstärkt werden.

Eine wellenlängenselektive Beschichtung kann beispielsweise lichteintrittsseitig, wie in Figur 12 schematisch gepunktet bei der Oberfläche 241 dargestellt, und/oder an der Lichtaustrittsseite seitens der Oberfläche 242, was in Figur 12 nicht dargestellt ist, vorgesehen sein. Lichteintritts-und Lichtaustrittsseite beziehen sich hierbei auf vom Strahlungsumlenkelement her auf das Wellenlängenselektionselement auftreffende Strahlung.

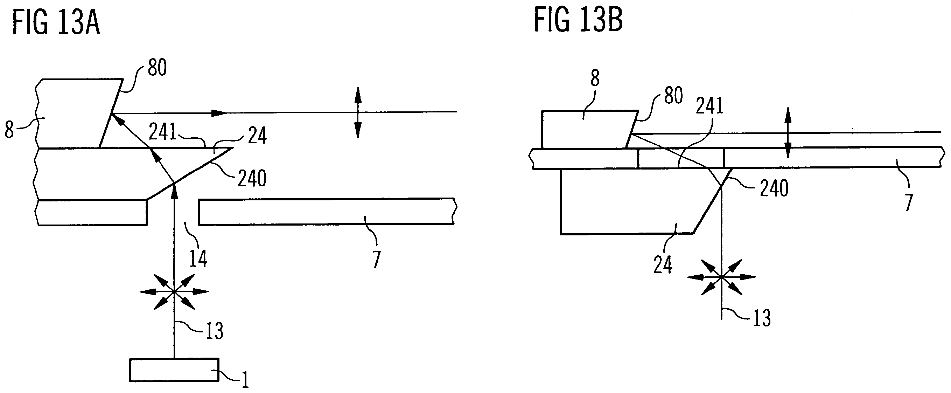

In Figur 13 ist ein dreizehntes Ausführungsbeispiel eines erfindungsgemäßen Halbleiterlaserbauelements anhand von Detailschnittansichten einer ersten Variante in Figur 13A und einer zweiten Variante in Figur 13B schematisch dargestellt.

Im Unterschied zu Figur 12 ist das Wellenlängenselektionselement 24 in Figur 13 im Strahlengang der vom Halbleiterlaserchip 1 her auf das Strahlungsumlenkelement 8 einfallenden Strahlung angeordnet. Die Strahlung 13 trifft seitens der Oberfläche 240 auf das Wellenlängenselektionselement, wird dort gebrochen, durchquert das Wellenlängenselektionselement und wird lichtaustrittsseitig an der Oberfläche 241 in Richtung des Strahlungsumlenkelements gelenkt.

Zusätzlich zur wellenlängenselektiven Wirkung über die Dispersion in dem Wellenlängenselektionselement 24 kann das Wellenlängenselektionselement auch zur Polarisationsselektion ausgebildet sein. Hierzu ist zweckmäßigerweise die Oberfläche 240 derart ausgebildet, dass die Strahlung 13 zumindest annähernd unter dem Brewsterwinkel auf diese Oberfläche trifft. In der Folge sind die Reflexionsverluste, die s-polarisiertes Licht an der Oberfläche 240 erfährt, verglichen mit p-polarisiertem Licht erhöht. Somit wird vermehrt p-polarisiertes Licht in Richtung des Strahlungsumlenkelements 8 gelenkt (s-polarisiert bezeichnet eine lineare Polarisation senkrecht zur Einfallsebene und p-polarisiert eine lineare Polarisation parallel zur Einfallsebene).

In der Variante gemäß Figur 13A ist das Wellenlängenselektionselement 24 seitens des Strahlungsumlenkelement auf dem Träger 7, vorzugsweise zwischen Strahlungsumlenkelement und Träger, angeordnet.

In der Variante gemäß Figur 13B ist das Wellenlängenselektionselement 24 auf der dem Strahlungsumlenkelement gegenüberliegenden Seite des Trägers 7 befestigt und kann beispielsweise die Aussparung 14 vollständig überdecken. Auch in der Variante in Figur 13B kann das Wellenlängenselektionselement 24 zugleich als Polarisationsselektionselement ausgebildet sein.

Der Polarisationszustand der Strahlung im Resonator ist durch die Pfeile schematisch angedeutet, wobei bei vom Halbleiterlaserchip emittierter Strahlung eher ein unpolarisierter Zustand und nach dem Auftreffen der Strahlung unter dem Brewsterwinkel auf bzw. nach dem Durchgang durch das Wellenlängenselektionselement eher p-Polarisation überwiegt.

In einer weiteren bevorzugten Ausgestaltung der Erfindung weist das Strahlungsumlenkelement eine unebene, vorzugsweise gekrümmte, Oberfläche auf, die der Strahlformung dient. Beispielsweise ist diese Oberfläche sphärisch, asphärisch, konkav oder konvex gekrümmt ausgeführt und kann beispielsweise mittels Prägen, Schleifen, Ätzen oder Abformen am Strahlungsumlenkelement erzeugt werden. Besonders bevorzugt ist die Oberfläche mit verschiedenen Krümmungsradien, insbesondere biradial, gekrümmt ausgeführt, um einem Astigmatismus der Strahlung im Resonator vorzubeugen. Eine biradiale Ausführung hat sich bei einer sphärischen Krümmung als besonders vorteilhaft erwiesen. Ein unter einem Einfallswinkel von 45° auftretender Astigmatismus kann so vermieden werden

Gegebenenfalls kann gemäß einer vorteilhaften Weiterbildung der Erfindung eine gekrümmte Oberfläche zur Strahlformung und/oder zur Strahlungsumlenkung durch Reflexion, eventuell mit entsprechender Beschichtung, auch an einer Endfläche des nichtlinearen optischen Elements vorgesehen sein. Insbesondere kann der externe Spiegel durch eine entsprechende (teil)reflektierende Beschichtung einer Endfläche des nichtlinearen optischen Elements ausgebildet werden.

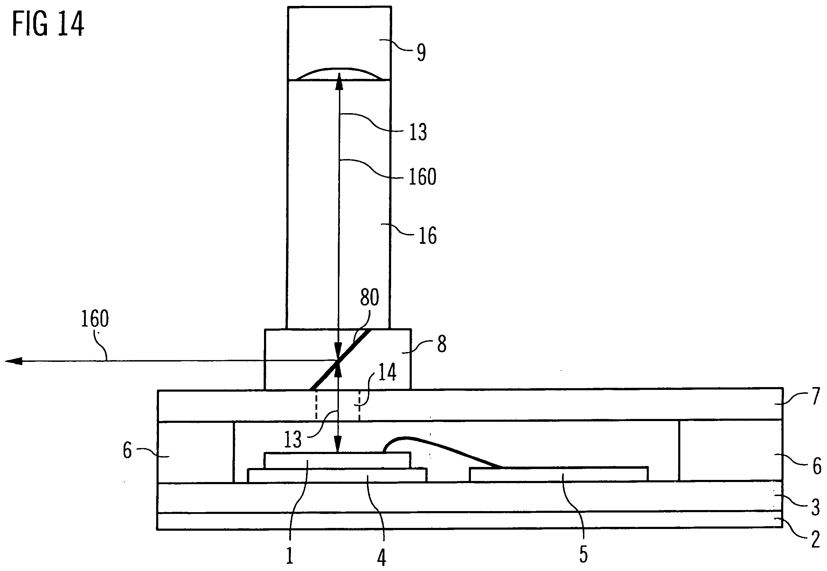

In Figur 14 ist ein vierzehntes Ausführungsbeispiel eines erfindungsgemäßen Halbleiterlaserbauelements anhand einer Schnittansicht schematisch dargestellt.

Im Gegensatz zu den vorhergehenden Ausführungsbeispielen, die im wesentlichen laterale Anordnungen für die optische Vorrichtung zeigen, ist in Figur 14 eine optische Vorrichtung in vertikaler Anordnung mit einem externem Spiegel 9, der vertikal von dem Träger 7 beabstandet ist, dargestellt.

Der externe Spiegel ist vom Träger über das Strahlungsumlenkelement 8, das vorzugsweise als Strahlteiler ausgeführt ist, und das nichtlineare optische Element 16 beabstandet. Im Halbleiterlaserchip 1 erzeugte Strahlung 13 wird durch das Strahlungsumlenkelement und das nichtlineare optische Element zum externen Spiegel 9 hingestrahlt, frequenzkonvertierte Strahlung 160 und Strahlung 13 werden am externen Spiegel reflektiert und nach erneutem Durchgang durch das nichtlineare optische Element wird die frequenzkonvertierte Strahlung durch Reflexion, vorzugsweise um ungefähr 90° zur Einfallsrichtung, an der Reflektorfläche 80 und Austritt aus dem Strahlüngsumlenkelement, vorzugsweise im wesentlichen parallel zur Haupterstreckungsrichtung des Trägers 7, aus dem Resonator ausgekoppelt. Die Strahlung 13 wird dem Halbleiterlaserchip 1 zur weitergehenden Verstärkung zugeführt.

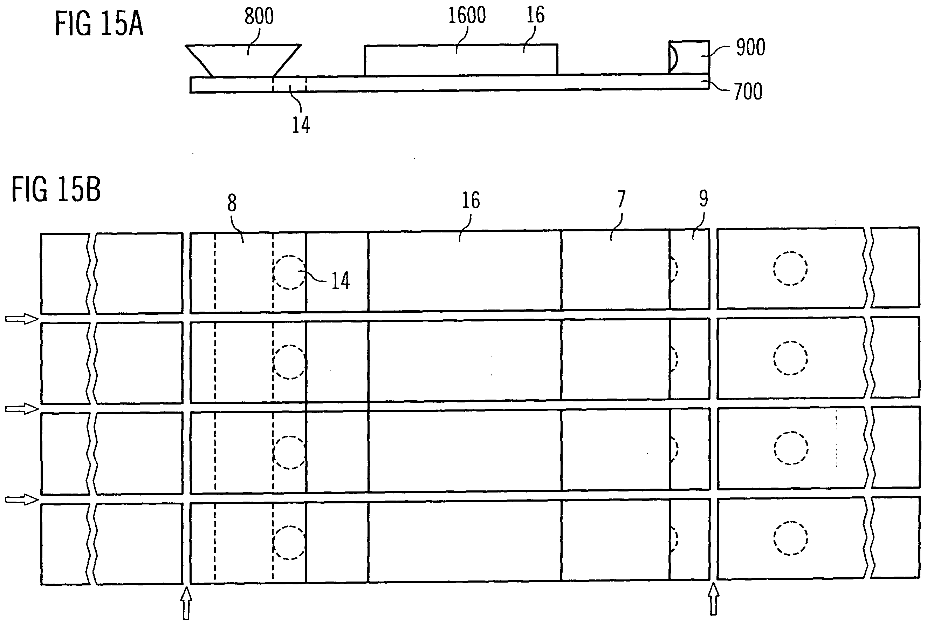

In Figur 15 ist ein Ausführungsbeispiel eines erfindungsgemäßen Herstellungsverfahrens anhand einer Schnittansicht in Figur 15A und einer Aufsicht in Figur 15B schematisch dargestellt.

Figur 15 zeigt ein Verfahren zur gleichzeitigen Herstellung einer Mehrzahl von optischen Vorrichtungen. Hierzu werden auf einer Trägerschicht 700, etwa einer 6" Silizium Scheibe, ein Strahlungsumlenkstreifen 800, der für die Ausbildung einer Mehrzahl von Umlenkelementen vorgesehen ist, und ein Spiegelstreifen 900 der zur Ausbildung einer Mehrzahl externer Spiegel vorgesehen ist, auf der Trägerschicht 700 angeordnet und mittels anodischem Bonden befestigt.

Weiterhin kann in die Trägerschicht, gegebenenfalls bereits vor der Montage des Strahlungsumlenkstreifens 800 oder des Spiegelstreifens 900, eine Mehrzahl von für die späteren optischen Vorrichtungen vorgesehenen Aussparungen 14, etwa eine Bohrung, ein gesägter Spalt oder eine Lochätzung, eingebracht werden. Im Verbund auf der Trägerschicht können Strahlungsumlenkstreifen 800 und Spiegelstreifen 900 mit Vorteil schon entsprechend einer späteren optischen Vorrichtung auf der Trägerschicht 700 angeordnet und zueinander justiert werden. Vorzugsweise werden der Strahlungsumlenkstreifen und der Spiegelstreifen vor der Befestigung auf der Trägerschicht zueinander entsprechend der späteren optischen Vorrichtung justiert. Die Aussparungen werden bevorzugt vor dem Anordnen der Elemente auf der Trägerschicht in diese eingebracht.

Ferner kann im Verfahren auch ein nichtlineares optisches Element als Streifen 1600, der zur Ausbildung einer Mehrzahl nichtlinearer optischer Elemente vorgesehen ist, oder als einzelnes nichtlineares optisches Element 16 gemäß den späteren optischen Vorrichtungen auf der Trägerschicht angeordnet und befestigt werden. Beispielsweise kann das nichtlineare optische Element beziehungsweise der Streifen auf die Trägerschicht geklebt oder gelötet werden. Durch eine Lotverbindung kann eine besonders effiziente thermische Ankopplung des nichtlinearen optischen Elements an ein, vorzugsweise in der Trägerschicht integriertes, Temperierungselement erreicht werden.

Beabstandungselemente können durch Ätzen, etwa als Meseten aus einer Silizium Trägerschicht, von der dem Strahlungsumlenkstreifen und dem Spiegelstreifen abgewandten Seite aus der Trägerschicht herausstrukturiert werden oder als separate Elemente an der Trägerschicht befestigt werden.

Zur Herstellung des Spiegelstreifens kann beispielsweise zunächst eine zweidimensionale flächige Spiegelstruktur, etwa durch entsprechendes Prägen in ein Substrat, beispielsweise aus einem Glas, und eventuelle (teil)reflektierende Beschichtungen, vorgefertigt werden. Aus der Spiegelstruktur kann in der Folge eine Mehrzahl von Spiegelstreifen gewonnen werden.

Wie in Figur 15B anhand einer Aufsicht schematisch dargestellt, kann nach der Befestigung der einzelnen Elemente entlang der Pfeile in eine Mehrzahl von optischen Vorrichtungen jeweils mit einem Strahlungsumlenkelement 8 und einem externen Spiegel 9 sowie gegebenenfalls einem nichtlinearen optischen Element 16 vereinzelt werden. Beispielsweise kann das Vereinzeln durch Sägen erfolgen.

Es sei angemerkt, dass auf der Trägerschicht selbstverständlich eine Mehrzahl von Strahlungsumlenk- oder Spiegelstreifen angeordnet werden kann.

Insgesamt wird durch das Verfahren eine effiziente Herstellung einer Mehrzahl von optischen Vorrichtungen erleichtert.

## Patentansprüche

1. Halbleiterlaserbauelement mit einem zur Strahlungserzeugung vorgesehenen Halbleiterlaserchip (1) und einer optischen Vorrichtung, die einen Träger (7), ein auf dem Träger angeordnetes Strahlungsumlenkelement (8) und einen auf dem Träger angeordneten Spiegel umfasst, wobei
- der Spiegel als externer Spiegel (9) eines externen optischen Resonators für den Halbleiterlaserchip (1) ausgebildet ist,
- das Strahlungsumlenkelement innerhalb des Resonators angeordnet ist,
- der externe Spiegel und das Strahlungsumlenkelement auf dem Träger befestigt sind,
- das Strahlungsumlenkelement zur Umlenkung zumindest eines Teils einer vom Halbleiterlaserchip (1) erzeugten und vom externen Spiegel reflektierten Strahlung (13,160) ausgebildet ist,
- der Träger eine laterale Haupterstreckungsrichtung aufweist,
- der Halbleiterlaserchip auf einem Chipträger (2, 3) vormontiert ist, der Anschlüsse zur elektrischen Kontaktierung des Halbleiterlaserchips oder einer Pumpstrahlungsquelle umfasst,
- der Halbleiterlaserchip (1) dem Träger in vertikaler Richtung zur lateralen Haupterstreckungsrichtung nachgeordnet ist, wobei der Träger vom Halbleiterlaserchip mittels mindestens eines Beabstandungselementes (6) beabstandet ist,
- die optische Vorrichtung dem Halbleiterlaserchip als Resonatoraufsatz aufgesetzt ist,
- die optische Vorrichtung mittels des Beabstandungselementes am Chipträger befestigt ist,
**dadurch gekennzeichnet, dass**
- der Halbleiterlaserchip ein oberflächenemittierender Halbleiterlaserchip ist, und
- der Träger und der Halbleiterlaserchip so zueinander angeordnet sind, dass die vom Halbleiterlaserchip vertikal emittierte Strahlung im wesentlichen senkrecht zu einer Hauptfläche des Trägers abgestrahlt wird und vom Strahlungsumlenkelement in eine Richtung parallel zur Hauptfläche des Trägers umgelenkt wird.

2. Halbleiterlaserbauelement nach Anspruch 1, **dadurch gekennzeichnet, dass**
der externe Spiegel (9) einen Resonatorendspiegel bildet.

3. Halbleiterlaserbauelement nach mindestens einem der vorhergehenden Ansprüche,
**dadurch gekennzeichnet, dass**
das Strahlungsumlenkelement (8) und/oder der externe Spiegel (9) mittels einer durch anodisches Bonden, Kleben oder Löten ausgebildeten Verbindung auf dem Träger (7) befestigt ist.

4. Halbleiterlaserbauelement nach mindestens einem der vorhergehenden Ansprüche,
**dadurch gekennzeichnet, dass**
das Strahlungsumlenkelement (8) zwischen Träger (7) und externem Spiegel (9) angeordnet ist.

5. Halbleiterlaserbauelement nach mindestens einem der Ansprüche 1 bis 4, **dadurch gekennzeichnet, dass**
das Strahlungsumlenkelement (8) und der externe Spiegel (9) lateral nebeneinander angeordnet sind.

6. Halbleiterlaserbauelement nach Anspruch 1, **dadurch gekennzeichnet, dass**
das Strahlungsumlenkelement (8) die vom Halbleiterlaserchip (1) emittierte Strahlung im wesentlichen parallel zur lateralen Haupterstreckungsrichtung des Trägers (7) zum externen Spiegel (9) hin umlenkt.

7. Halbleiterlaserbauelement nach mindestens einem der vorhergehenden Ansprüche,
**dadurch gekennzeichnet, dass**
der Halbleiterlaserchip (1) zur Strahlungserzeugung mittels einer oder mehrerer Pumpstrahlungsquellen optisch gepumpt ist.

8. Halbleiterlaserbauelement nach Anspruch 7, **dadurch gekennzeichnet, dass**
die Pumpstrahlungsquelle(n) und ein zu pumpender aktiver Bereich des Halbleiterlaserchips (1) monolithisch in den Halbleiterlaserchip (1) integriert sind.

9. Halbleiterlaserbauelement nach mindestens einem der vorhergehenden Ansprüche,
**dadurch gekennzeichnet, dass**
der Träger (7) vom Halbleiterlaserchip (1) mittels einer Mehrzahl von Beabstandungselementen beabstandet ist.

10. Halbleiterlaserbauelement nach mindestens einem der vorhergehenden Ansprüche,
**dadurch gekennzeichnet, dass**
der Träger (7) ein Glas oder ein Halbleitermaterial, vorzugsweise Si, enthält.

11. Halbleiterlaserbauelement nach mindestens einem der vorhergehenden Ansprüche,
**dadurch gekennzeichnet, dass**
die optische Vorrichtung als Gehäuseteil für ein Gehäuse des Halbleiterlaserbauelements ausgebildet ist.

12. Halbleiterlaserbauelement nach mindestens einem der vorhergehenden Ansprüche,
**dadurch gekennzeichnet, dass**
der Träger (7) als Gehäusedeckel ausgebildet ist und die Beabstandungselemente (6) als Gehäusewandung ausgebildet sind.

13. Halbleiterlaserbauelement nach mindestens einem der vorhergehenden Ansprüche,
**dadurch gekennzeichnet, dass**
das Strahlungsumlenkelement (8) und der externe Spiegel (9) auf der dem Halbleiterlaserchip (1) zugewandten Seite des Trägers (7) angeordnet sind.

14. Halbleiterlaserbauelement nach mindestens einem der Ansprüche 1 bis 12, **dadurch gekennzeichnet, dass**
das Strahlungsumlenkelement (8) und der externe Spiegel (9) auf der dem Halbleiterlaserchip (1) abgewandten Seite des Trägers (7) angeordnet sind.

15. Halbleiterlaserbauelement nach mindestens einem der vorhergehenden Ansprüche,
**dadurch gekennzeichnet, dass**
im Resonator ein nichtlineares optisches Element (16) zur Frequenzkonversion, vorzugsweise zur Frequenzvervielfachung, angeordnet ist.

16. Halbleiterlaserbauelement nach Anspruch 15, **dadurch gekennzeichnet, dass**
das nichtlineare optische Element (16) auf dem Träger (7) angeordnet und/oder befestigt ist.

17. Halbleiterlaserbauelement nach Anspruch 15 oder 16, **dadurch gekennzeichnet, dass**
das nichtlineare optische Element (16) zwischen dem externen Spiegel (9) und dem Träger (7) angeordnet ist.

18. Halbleiterlaserbauelement nach mindestens einem der Ansprüche 15 bis 17, **dadurch gekennzeichnet, dass**
das nichtlineare optische Element (16) zwischen dem externen Spiegel (9) und dem Strahlungsumlenkelement (8) angeordnet ist.

19. Halbleiterlaserbauelement nach mindestens einem der Ansprüche 15 bis 18, **dadurch gekennzeichnet, dass**
das nichtlineare optische Element (16) über ein Temperierungselement (19) temperierbar ist.

20. Halbleiterlaserbauelement nach Anspruch 19, **dadurch gekennzeichnet, dass**
das Temperierungselement (19), vorzugsweise als Heizwiderstand, im Träger (7) integriert ist.

21. Halbleiterlaserbauelement nach mindestens einem der vorhergehenden Ansprüche,
**dadurch gekennzeichnet, dass**
das Strahlungsumlenkelement (8) zur Strahlungsauskopplung von Strahlung, vorzugsweise der frequenzkonvertierten Strahlung (160), aus dem Resonator ausgebildet ist.

22. Halbleiterlaserbauelement nach Anspruch 21, **dadurch gekennzeichnet, dass**
die Strahlungsauskopplung aus dem Resonator durch das Strahlungsumlenkelement (8) unter interner Totalreflexion im Strahlungsumlenkelement erfolgt.

23. Halbleiterlaserbauelement nach mindestens einem der vorhergehenden Ansprüche,
**dadurch gekennzeichnet, dass**
das Strahlungsumlenkelement (8) ein Prisma ist.

24. Halbleiterlaserbauelement nach mindestens einem der vorhergehenden Ansprüche,
**dadurch gekennzeichnet, dass**
das Strahlungsumlenkelement (8) ein Strahlteiler ist.

25. Verfahren zum Herstellen einer optischen Vorrichtung, die als Resonatoraufsatz für ein Halbleiterlaserbauelement nach mindestens einem der vorhergehenden Ansprüche mit einem auf einem Chipträger(2, 3), der Anschlüsse zur elektrischen Kontaktierung des Halbleiterlaserchips oder einer Pumpstrahlungsquelle umfasst, vormontierten Halbleiterlaserchip vorgesehen ist,
**gekennzeichnet durch** die Schritte,
- Bereitstellen eines Trägers (7),
- Anordnen eines Strahlungsumlenkelements (8) auf dem Träger,
- Anordnen eines externen Spiegels (9) auf dem Träger,
- Befestigen des externen Spiegels und des Strahlungsumlenkelements auf dem Träger,
- Ausbilden eines Beabstandungselementes (6) im Träger oder Befestigen eines Beabstandungselementes am Träger, wobei das Beabstandungselement zur Befestigung der optischen Vorrichtung am Chipträger vorgesehen ist, und
- Fertigstellen der optischen Vorrichtung.

26. Verfahren nach Anspruch 25, **dadurch gekennzeichnet, dass**
das Strahlungsumlenkelement (8) und/oder der externe Spiegel (9) mittels anodischem Bonden auf dem Träger (7) befestigt werden.

27. Verfahren nach Anspruch 25 oder 26, **dadurch gekennzeichnet, dass**
zwischen dem Strahlungsumlenkelement (8) und dem externen Spiegel (9) ein nichtlineares optisches Element (16) auf dem Träger (7) angeordnet und/oder befestigt wird.

28. Verfahren nach mindestens einem der Ansprüche 25 bis 27, **dadurch gekennzeichnet, dass**
das Verfahren zur gleichzeitigen Herstellung einer Mehrzahl optischer Vorrichtungen ausgebildet ist.

## Claims

1. A semiconductor laser component comprising a semiconductor laser chip (1) provided for generating radiation and an optical device comprising a carrier (7), a radiation deflecting element (8) arranged on the carrier and a mirror arranged on the carrier, wherein
- the mirror is formed as an external mirror (9) of an external optical resonator for the semiconductor laser chip (1),
- the radiation deflecting element is arranged within the resonator,
- the external mirror and the radiation deflecting element are fixed on the carrier,
- the radiation deflecting element is formed for deflecting at least one portion of a radiation (13, 160) that is generated by the semiconductor laser chip (1) and reflected by the external mirror,
- the carrier has a lateral main extension direction,
- the semiconductor laser chip is pre-mounted on a chip carrier (2, 3) comprising connections for electrically contacting the semiconductor laser chip or a pump radiation source,
- the semiconductor laser chip (1) is disposed downstream of the carrier in a vertical direction with respect to the lateral main extension direction, wherein the carrier is spaced apart from the semiconductor laser chip by means of at least one spacer element (6),
- the optical device is attached to the semiconductor laser chip as a resonator attachment,
- the optical device is fixed to the chip carrier by means of the spacer element,
**characterized in that**
- the semiconductor laser chip is a surface emitting semiconductor laser chip, and
- the carrier and the semiconductor laser chip are arranged with respect to one another such that the radiation emitted vertically by the semiconductor laser chip is emitted substantially perpendicularly to a main surface of the carrier and is deflected by the radiation deflecting element in a direction parallel to the main surface of the carrier.

2. The semiconductor laser component according to Claim 1,
**characterized in that**
the external mirror (9) forms a resonator end mirror.

3. The semiconductor laser component according to at least one of the preceding claims,
**characterized in that**
the radiation deflecting element (8) and/or the external mirror (9) is fixed on the carrier (7) by means of a connection formed by anodic bonding, adhesive bonding or soldering.

4. The semiconductor laser component according to at least one of the preceding claims,
**characterized in that**
the radiation deflecting element (8) is arranged between carrier (7) and external mirror (9).

5. The semiconductor laser component according to at least one of Claims 1 to 4,
**characterized in that**
the radiation deflecting element (8) and the external mirror (9) are arranged laterally alongside one another.

6. The semiconductor laser component according to Claim 1,
**characterized in that**
the radiation deflecting element (8) deflects the radiation emitted by the semiconductor laser chip (1) essentially parallel to the lateral main extension direction of the carrier (7) toward the external mirror (9).

7. The semiconductor laser component according to at least one of the preceding claims,
**characterized in that**
the semiconductor laser chip (1) is optically pumped by means of one or more pump radiation sources for generating radiation.

8. The semiconductor laser component according to Claim 7,
**characterized in that**
the pump radiation source(s) and an active region to be pumped in the semiconductor laser chip (1) are monolithically integrated into the semiconductor laser chip (1).

9. The semiconductor laser component according to at least one of the preceding claims,
**characterized in that**
the carrier (7) is spaced apart from the semiconductor laser chip (1) by means of a plurality of spacer elements.

10. The semiconductor laser component according to at least one of the preceding claims,
**characterized in that**
the carrier (7) contains a glass or a semiconductor material, preferably Si.

11. The semiconductor laser component according to at least one of the preceding claims,
**characterized in that**
the optical device is formed as a housing part for a housing of the semiconductor laser component.

12. The semiconductor laser component according to at least one of the preceding claims,
**characterized in that**
the carrier (7) is formed as a housing cover and the spacer elements (6) are formed as a housing wall.

13. The semiconductor laser component according to at least one of the preceding claims,
**characterized in that**
the radiation deflecting element (8) and the external mirror (9) are arranged on that side of the carrier (7) which faces the semiconductor laser chip (1).

14. The semiconductor laser component according to at least one of Claims 1 to 12,
**characterized in that**
the radiation deflecting element (8) and the external mirror (9) are arranged on that side of the carrier (7) which is remote from the semiconductor laser chip (1).

15. The semiconductor laser component according to at least one of the preceding claims,
**characterized in that**
a nonlinear optical element (16) for frequency conversion, preferably for frequency multiplication, is arranged in the resonator.

16. The semiconductor laser component according to Claim 15,
**characterized in that**
the nonlinear optical element (16) is arranged and/or fixed on the carrier (7).

17. The semiconductor laser component according to Claim 15 or 16,
**characterized in that**
the nonlinear optical element (16) is arranged between the external mirror (9) and the carrier (7).

18. The semiconductor laser component according to at least one of Claims 15 to 17,
**characterized in that**
the nonlinear optical element (16) is arranged between the external mirror (9) and the radiation deflecting element (8).

19. The semiconductor laser component according to at least one of Claims 15 to 18,
**characterized in that**
the nonlinear optical element (16) can be temperature-regulated by means of a temperature regulating element (19).

20. The semiconductor laser component according to Claim 19, **characterized in that**
the temperature regulating element (19), preferably as a heating resistor, is integrated in the carrier (7).

21. The semiconductor laser component according to at least one of the preceding claims,
**characterized in that**
the radiation deflecting element (8) is formed for the radiation coupling out of radiation, preferably the frequency-converted radiation (160), from the resonator.

22. The semiconductor laser component according to Claim 21,
**characterized in that**
the radiation coupling out from the resonator by the radiation deflecting element (8) is effected with total internal reflection in the radiation deflecting element.

23. The semiconductor laser component according to at least one of the preceding claims,
**characterized in that**
the radiation deflecting element (8) is a prism.

24. The semiconductor laser component according to at least one of the preceding claims,
**characterized in that**
the radiation deflecting element (8) is a beam splitter.

25. A method for producing an optical device provided as a resonator attachment for a semiconductor laser component according to at least one of the preceding claims comprising a semiconductor laser chip pre-mounted on a chip carrier (2, 3) comprising connections for electrically contacting the semiconductor laser chip or a pump radiation source, **characterized by** the steps of
- providing a carrier (7),
- arranging a radiation deflecting element (8) on the carrier,
- arranging an external mirror (9) on the carrier,
- fixing the external mirror and the radiation deflecting element on the carrier,
- forming a spacer element (6) in the carrier or fixing a spacer element on the carrier, wherein the spacer element is provided for fixing the optical device on the chip carrier, and
- completing the optical device.

26. The method according to Claim 25,
**characterized in that**
the radiation deflecting element (8) and/or the external mirror (9) are fixed on the carrier (7) by means of anodic bonding.

27. The method according to Claim 25 or 26,
**characterized in that**
a nonlinear optical element (16) is arranged and/or fixed on the carrier (7) between the radiation deflecting element (8) and the external mirror (9).

28. The method according to at least one of Claims 25 to 27,
**characterized in that**
the method is designed for simultaneously producing a plurality of optical devices.

## Revendications

1. Composant laser semiconducteur comprenant une puce laser en semiconducteur (1) destinée à générer un rayonnement et un dispositif optique qui comporte un support (7), un élément de déviation de rayonnement (8) disposé sur le support et un miroir disposé sur le support,
- le miroir étant réalisé sous la forme d'un miroir externe (9) d'un résonateur optique externe pour la puce laser en semiconducteur (1),
- l'élément de déviation de rayonnement étant disposé à l'intérieur du résonateur,
- le miroir externe et l'élément de déviation de rayonnement étant fixés sur le support,
- l'élément de déviation de rayonnement étant configuré pour dévier au moins une partie d'un rayonnement (13, 160) généré par la puce laser en semiconducteur (1) et réfléchi par le miroir externe,
- le support possédant un sens de projection principal latéral,
- la puce laser en semiconducteur étant pré-montée sur un porte-puce (2, 3) qui comporte des bornes destinées à la mise en contact électrique de la puce laser en semiconducteur ou d'une source de rayonnement de pompage,
- la puce laser en semiconducteur (1) étant disposée à la suite du support dans la direction verticale par rapport au sens de projection principal, le support étant espacé de la puce laser en semiconducteur au moyen d'au moins un élément d'espacement (6),
- le dispositif optique étant posé sur la puce laser en semiconducteur en tant que chapeau résonateur,
- le dispositif optique étant fixé au porte-puce au moyen de l'élément d'espacement,
**caractérisé en ce que**
- la puce laser en semiconducteur est une puce laser en semiconducteur à émission par la surface, et
- le support et la puce laser en semiconducteur sont disposés l'un par rapport à l'autre de telle sorte que le rayonnement émis verticalement par la puce laser en semiconducteur est irradié sensiblement perpendiculairement à une surface principale du support et il est dévié par l'élément de déviation de rayonnement dans une direction parallèle à la surface principale du support.

2. Composant laser semiconducteur selon la revendication 1, **caractérisé en ce que** le miroir externe (9) forme un miroir final de résonateur.

3. Composant laser semiconducteur selon au moins l'une des revendications précédentes,
**caractérisé en ce que** l'élément de déviation de rayonnement (8) et/ou le miroir externe (9) sont fixés sur le support (7) au moyen d'une liaison formée par liage anodique, collage ou brasage.

4. Composant laser semiconducteur selon au moins l'une des revendications précédentes,
**caractérisé en ce que** l'élément de déviation de rayonnement (8) est disposé entre le support (7) et le miroir externe (9).

5. Composant laser semiconducteur selon au moins l'une des revendications 1 à 4,
**caractérisé en ce que** l'élément de déviation de rayonnement (8) et le miroir externe (9) sont disposés latéralement l'un à côté de l'autre.

6. Composant laser semiconducteur selon la revendication 1,
**caractérisé en ce que** l'élément de déviation de rayonnement (8) dévie le rayonnement émis par la puce laser en semiconducteur (1) sensiblement en parallèle du sens de projection principal latéral du support (7) vers le miroir externe (9).

7. Composant laser semiconducteur selon au moins l'une des revendications précédentes,
**caractérisé en ce que** la puce laser en semiconducteur (1) est pompée optiquement au moyen d'une ou plusieurs sources de rayonnement de pompage en vue de générer le rayonnement.

8. Composant laser semiconducteur selon la revendication 7,
**caractérisé en ce que** la ou les sources de rayonnement de pompage et une zone active à pomper de la puce laser en semiconducteur (1) sont intégrées de manière monolithique dans la puce laser en semiconducteur (1).

9. Composant laser semiconducteur selon au moins l'une des revendications précédentes,
**caractérisé en ce que** le support (7) est espacé de la puce laser en semiconducteur (1) au moyen d'une pluralité d'éléments d'espacement.

10. Composant laser semiconducteur selon au moins l'une des revendications précédentes,
**caractérisé en ce que** le support (7) contient un verre ou un matériau semiconducteur, de préférence du Si.

11. Composant laser semiconducteur selon au moins l'une des revendications précédentes,
**caractérisé en ce que** le dispositif optique est réalisé sous la forme d'une partie de boîtier pour un boîtier du composant laser semiconducteur.

12. Composant laser semiconducteur selon au moins l'une des revendications précédentes,
**caractérisé en ce que** le support (7) est réalisé sous la forme d'un couvercle de boîtier et les éléments d'espacement (6) sont réalisés sous la forme d'une paroi de boîtier.

13. Composant laser semiconducteur selon au moins l'une des revendications précédentes,
**caractérisé en ce que** l'élément de déviation de rayonnement (8) et le miroir externe (9) sont disposés sur le côté du support (7) qui fait face à la puce laser en semiconducteur (1).

14. Composant laser semiconducteur selon au moins l'une des revendications 1 à 12,
**caractérisé en ce que** l'élément de déviation de rayonnement (8) et le miroir externe (9) sont disposés sur le côté du support (7) à l'opposé de la puce laser en semiconducteur (1).

15. Composant laser semiconducteur selon au moins l'une des revendications précédentes,
**caractérisé en ce qu'**un élément optique non linéaire (16) destiné à la conversion de fréquence, de préférence destiné à la multiplication de fréquence, est disposé dans le résonateur.

16. Composant laser semiconducteur selon la
revendication 15,
**caractérisé en ce que** l'élément optique non linéaire (16) est disposé et/ou fixé sur le support (7).

17. Composant laser semiconducteur selon la revendication 15 ou 16,
**caractérisé en ce que** l'élément optique non linéaire (16) est disposé entre le miroir externe (9) et le support (7).

18. Composant laser semiconducteur selon au moins l'une des revendications 15 à 17,
**caractérisé en ce que** l'élément optique non linéaire (16) est disposé entre le miroir externe (9) et l'élément de déviation de rayonnement (8).

19. Composant laser semiconducteur selon au moins l'une des revendications 15 à 18,
**caractérisé en ce que** l'élément optique non linéaire (16) peut être amené en équilibre thermique par le biais d'un élément d'équilibrage thermique (19).

20. Composant laser semiconducteur selon la revendication 19,
**caractérisé en ce que** l'élément d'équilibrage thermique (19) est intégré dans le support (7), de préférence sous la forme d'une résistance chauffante.

21. Composant laser semiconducteur selon au moins l'une des revendications précédentes,
**caractérisé en ce que** l'élément de déviation de rayonnement (8) est configuré pour le découplage du rayonnement, de préférence du rayonnement converti en fréquence (160), hors du résonateur.

22. Composant laser semiconducteur selon la revendication 21,
**caractérisé en ce que** le découplage du rayonnement hors du résonateur par l'élément de déviation de rayonnement (8) est effectué sous une réflexion totale interne dans l'élément de déviation de rayonnement.

23. Composant laser semiconducteur selon au moins l'une des revendications précédentes,
**caractérisé en ce que** l'élément de déviation de rayonnement (8) est un prisme.

24. Composant laser semiconducteur selon au moins l'une des revendications précédentes,
**caractérisé en ce que** l'élément de déviation de rayonnement (8) est un séparateur de faisceaux.

25. Procédé de fabrication d'un dispositif optique, lequel est conçu comme un chapeau résonateur pour un composant laser semiconducteur selon au moins l'une des revendications précédentes, comprenant une puce laser en semiconducteur (1) pré-montée sur un porte-puce (2, 3), lequel comporte des bornes destinées à la mise en contact électrique de la puce laser en semiconducteur ou d'une source de rayonnement de pompage,
**caractérisé par** les étapes suivantes:
- mise à disposition d'un support (7),
- disposition d'un élément de déviation de rayonnement (8) sur le support,
- disposition d'un miroir externe (9) sur le support,
- fixation du miroir externe et de l'élément de déviation de rayonnement sur le support,
- formation d'un élément d'espacement (6) dans le support ou fixation d'un élément d'espacement sur le support, l'élément d'espacement étant destiné à la fixation du dispositif optique au porte-puce, et
- achèvement du dispositif optique.

26. Procédé selon la revendication 25, **caractérisé en ce que** l'élément de déviation de rayonnement (8) et/ou le miroir externe (9) sont fixés sur le support (7) au moyen d'un liage anodique.

27. Procédé selon la revendication 25 ou 26, **caractérisé en ce qu'**un élément optique non linéaire (16) est disposé et/ou fixé sur le support (7) entre l'élément de déviation de rayonnement (8) et le miroir externe (9).

28. Procédé selon au moins l'une des`revendications 25 à 27, **caractérisé en ce que** le procédé est configuré pour fabriquer simultanément une pluralité de dispositifs optiques.
